# EUROPÄISCHE PATENTSCHRIFT

(11) **EP 0 470 118 B1**
(45) Veröffentlichungstag und Bekanntmachung des Hinweises auf die Patenterteilung: **19.10.1994**
(21) Anmeldenummer: 90906220.0
(22) Anmeldetag: 25.04.1990
(51) Int. Cl.: G01R 1/073, G01R 31/28, G01R 31/302

(54) **PRÜFVORRICHTUNG ZUM PRÜFEN VON ELEKTRISCHEN ODER ELEKTRONISCHEN PRÜFLINGEN**
TESTING DEVICE FOR TESTING ELECTRICAL OR ELECTRONIC TEST SPECIMENS
DISPOSITIF DE CONTROLE POUR CONTROLER DES ELEMENTS ELECTRIQUES OU ELECTRONIQUES

(30) Priorität: 26.04.1989 DE 3913796
(43) Veröffentlichungstag der Anmeldung: 12.02.1992
(73) Patentinhaber: ATG ELECTRONIC GmbH, 97877 Wertheim (DE)
(72) Erfinder: ARNAUDOV, Konstantin, D-6980 Wertheim (DE); PROKOPP, Manfred, D-6980 Wertheim (DE)
(74) Vertreter: Gleiss, Alf-Olav, Dr.jur. Dipl.-Ing.
(86) Internationale Anmeldenummer: EP9000668
(87) Internationale Veröffentlichungsnummer: WO9013039

(56) Entgegenhaltungen:
- EP-A- 0 130 350
- EP-A- 0 350 609
- DE-A- 3 705 714
- US-A- 4 038 599
- US-A- 4 566 184
- US-A- 4 585 991
- US-A- 4 672 314

## Beschreibung

Die Erfindung betrifft eine Prüfvorrichtung gemäß dem Oberbegriff des Anspruches 1.

Derartige Prüfvorrichtungen sind in zahlreichen Ausführungen bekannt (bspw. US-PS 4,443,756 und 4,528,500; DE-A-23 64 786; DE-C-233 43 274; Jahrbuch der Deutschen Gesellschaft für Chronometrie e.V., Band 30, S. 269 276). Den bekannten Prüfvorrichtungen ist gemeinsam, daß sie dem Kontaktieren von Prüfpunkten des jeweiligen Prüflings dienende Kontaktnadeln oder Federkontaktstifte aufweisen, denen gemeinsam ist, daß ihre zulässigen geringsten Mittenabstände voneinander verhältnismäßig groß sind.

Unter einem Tastpunkt der Prüfvorrichtung ist eine Stelle verstanden, welche dazu geeignet ist, falls ihr beim Prüfen eines Prüflings ein Prüfpunkt des Prüflings gegenübersteht, diesen Prüfpunkt mit der Prüfschaltung der Prüfvorrichtung zwecks Übertragung von Prüfsignalen zu verbinden. Der einzelne Tastpunkt kann durch eine einzige Fläche oder durch mehrere Flächen gebildet sein. Diese Fläche oder diese Flächen können vorzugsweise punktartig sein, jedoch auch andere Ausbildungen haben, bspw. linienförmig, kreisringförmig usw.

Ein Prüfpunkt des Prüflings ist eine Stelle oder eine Mehrzahl von Stellen des Prüflings, der oder den von der Prüfschaltung der Prüfvorrichtung über einen ihr gegenüberstehenden Tastpunkt dieser Prüfvorrichtung Prüfsignale zugeleitet oder von der oder den Prüfsignale über den betreffenden Tastpunkt der Prüfvorrichtung zur Prüfschaltung übertragen werden können. Ein Prüfpunkt des Prüflings kann bspw. mindestens eine Stelle einer Leiterbahn, eines Pads, eines metallischen Anschlusses, einer elektrischen oder elektronischen Komponente des Prüflings, einer Buchse oder dergleichen sein.

Ein Prüfsignal kann bspw. ein elektrischer Strom oder eine elektrische Spannung sein, die über einen Tastpunkt der Prüfvorrichtung einem zugeordneten Prüfpunkt des jeweiligen Prüflings zugeleitet bzw. mittels eines Tastpunktes der Prüfvorrichtung von einem Prüfpunkt des Prüflings zwecks Zuleitung zur Prüfschaltung der Prüfvorrichtung abgeleitet wird. Die Prüfschaltung der Prüfvorrichtung prüft dann bspw., zwischen welchen Prüfpunkten des jeweiligen Prüflings ein Prüfsignal übertragbar ist. Das Prüfsignal kann dem Prüfen dienen, zwischen welchen Prüfpunkten des betreffenden Prüflings elektrische Verbindungen bestehen, bspw. durch Leiterbahnen des Prüflings bewirkte elektrische Verbindungen oder unerlaubte Kurzschlüsse. Auch kann auf diese Weise festgestellt werden, ob zwischen vorbestimmten Prüfpunkten, die elektrisch miteinander verbunden sein sollen, unerlaubte Unterbrechungen vorliegen, die wie unerlaubte Kurzschlüsse ebenfalls Fehler des Prüflings darstellen. Prüfsignale können gewünschtenfalls auch Meßzwecken dienen, bspw. dem Messen von Eigenschaften elektronischer Komponenten von Prüflingen, oder ob solche Eigenschaften vorbestimmte Toleranzen nicht überschreiten usw. In der die Prüfsignale erzeugenden Prüfschaltung der Prüfvorrichtung werden dann die Prüfsignale bzw. das Ausbleiben zurückzuleitender Prüfsignale dahingehend ausgewertet, ob der jeweilige Prüfling elektrisch fehlerfrei oder fehlerhaft ist, wobei die Fehlerstellen eines Prüflings auch angezeigt oder koordinatenmäßig auf sonstige Weise ausgedruckt werden können. Auch andere Möglichkeiten bestehen.

Bei den bekannten Prüfvorrichtungen (bspw. US-PS 4,443,756 und 4,529,500; DE-A 23 64 786; DE-C-33 43 274; Jahrbuch der Deutschen Gesellschaft für Chronometrie e.V., Band 30, S. 269-276) der eingangs genannten Art ist jeder Tastpunkt durch den Kopf oder die Spitze eines metallischen Kontaktstiftes gebildet, der bspw. aus Stahl, Kupfer-Beryllium oder dergl. besteht. Der Kontaktstift kann ein axial federnd abgestützter Stift sein, oder eine gebogene oder gerade Nadel, die als Biegefeder oder Knicknadel wirkt. Oder er kann ein Federkontaktstift sein. Den bekannten Kontaktstiften ist gemeinsam, daß sie relativ viel Platz beanspruchen. Dies beschränkt die Anwendung solcher Prüfvorrichtungen und ihrer Prüfmöglichkeiten.

Aus der EP-A-0 130 350, von der ausgehend der Oberbegriff des vorliegenden Anspruchs 1 gebildet ist, ist eine Prüfvorrichtung zum Prüfen von elektrischen oder elektronischen Prüflingen bekannt, die Tastpunkte aufweist, die beim Prüfen eines Prüflings entsprechend den Prüfpunkten dieses Prüflings gegenüberstehen und der Übertragung von Prüfsignalen dienen. Aus der US-PS 4,038,599 ist eine weitere Prüfvorrichtung bekannt, bei der eine Halbleiterplatte vorgesehen ist, die Tastpunkte aufweist, die zur Kontaktierung von Prüfpunkten mittels geeigneter Kontaktmittel geeignet sind.

Es hat sich herausgestellt, daß es bei bekannten Prüfvorrichtungen häufig zu Fehlern bei der Übertragung von Prüfsignalen zwischen Tast- und Prüfpunkt kommt, so daß eine eindeutige Aussage über den technischen Zustand des Prüflings in vielen Fällen nicht möglich, zumindest jedoch nicht sicher ist.

Eine Prüfvorrichtung der hier angesprochenen Art ist auch aus der US-Patentschrift Nr. 4,585,991 bekannt. Sie weist der Funktionsprüfung von Prüflingen dienende Tastpunkte auf, die jeweils einem Kontaktbereich beziehungsweise Prüfpunkt der Prüflings so gegenüberliegend angeordnet sind, daß Prüfsignale zwischen Tast- und Prüfpunkt übertragen werden können. Insbesondere bei sehr kleinen Strukturen hat es sich gezeigt, daß häufig Prüfsignale zwischen Tast- und Prüfpunkt nicht übertragen werden können, weil die Ausrichtung zwischen Prüfvorrichtung und Prüfling deren Übertragung nicht in allen Fällen zuläßt. Damit werden zumindest einige Prüfpunkte als fehlerhaft angezeigt, die letztlich korrekt sind. Auf diese Weise werden auch technisch intakte Prüflinge als defekt ausgesondert, wodurch die Herstellungskosten derartiger Prüflinge erhöht werden.

Es ist daher Aufgabe der Erfindung, eine Prüfvorrichtung zu schaffen, die einen geringen Raumbedarf hat und die eine bessere Übertragungssicherheit sowohl bei der Abgabe als auch beim Empfang von Prüfsignalen gegenüber den bekannten Prüfvorrichtungen gewährleistet.

Diese Aufgabe wird bei einer Prüfvorrichtung zum Prüfen von elektrischen oder elektronischen Prüflingen mit Hilfe der in Anspruch 1 genannten Merkmale gelöst. Insbesondere durch die Tatsache, daß die Tastpunkte jeweils mit mindestens zwei entgegengesetzt dotierten Halbleitergebieten kontaktiert sind, die Teil einer Prüfschaltung sind, ist es möglich, bestimmte Tastpunkte ein- und abzuschalten, um bei der Prüfung der Prüfpunkte deren Funktion zu kontrollieren. Da die den Tastpunkten zugeordneten Halbleitergebiete der Prüfschaltung durch kurze, auf kleinstem Raum untergebrachte Leitungswege gekennzeichnet sind, läßt sich dabei eine hohe Schaltsicherheit und damit sehr exakte Prüfung des Prüflings realisieren.

Bevorzugt wird eine Ausführungsform der Prüfvorrichtung, die sich dadurch auszeichnet, daß die Tastpunkte an mikromechanisch hergestellten Strukturen und beziehungsweise Vorsprüngen der Oberfläche der Platte vorgesehen sind, die Ausgangspunkt der Tastpunkte ist. Es ist daher möglich, die Tastpunkte in einem sehr geringen Abstand zueinander anzuordnen, daß die Strukturen des gegenüberliegenden Prüflings, beispielsweise von Leiterbahnstrukturen und Pads des Prüflings, abgebildet und visuell oder selbsttätig auf Fehlerfreiheit geprüft werden können. Bei diesen besonders kleinen Abständen der Tastpunkte ergibt sich eine rasterartige - Abbildung, anhand derer Fehler des Prüflings ohne weiteres feststellbar sind.

Bei der Prüfvorrichtung weisen die Tastpunkte jeweils mindestens zwei dotierte Bereiche auf, die sich bis zur Stirnfläche der Tastpunkte erstrecken. Aufgrund dieser Ausgestaltung ergibt sich die Möglichkeit, festzustellen, ob ein Tastpunkt bei der Verwendung dieser Ausführungsform der Prüfvorrichtung mit dem Prüfpunkt eines Prüflings in Berührung steht. Durch die als Prüfpunkt bezeichnete Kontaktfläche des Prüflings werden die dotierten Gebiete der Tastpunkte im Bereich seiner Stirnfläche miteinander elektrisch leitend verbunden. Diese Verbindung kann auf geeignete, bekannte Weise festgestellt werden. So sind nicht mit den Prüflingen in Berührung stehende Tastpunkte vor und während des Prüfvorgangs ermittelbar. Bei einer Fehlermeldung kann also ohne weiteres festgestellt werden, ob diese auf einen fehlerhaften Prüfpunkt beziehungsweise Fehler des Prüflings oder auf einer nicht vollständigen Kontaktierung zwischen Tast- und Prüfpunkt beruht.

Besonders bevorzugt wird ein Ausführungsbeispiel der Prüfvorrichtung, bei der die Tastpunkte von den vorderen freien Enden von metallischen Kontaktnadeln gebildet werden, deren gegenüberliegende Enden je auf der Oberfläche der mikromechanisch hergestellten Strukturen, die als Widerlager ausgebildet sind, gelagert sind, und bei der die mindestens zwei entgegengesetzt dotierten Halbleitergebiete das Widerlager bilden. Es hat sich als besonders vorteilhaft herausgestellt, daß bei dieser Ausgestaltung der Prüfvorrichtung die Mittenabstände benachbarter Kontaktnadeln sehr gering gewählt werden können, so daß eine außerordentlich hohe Kontaktsicherheit bei der Übertragung von Prüfsignalen zwischen den Tastpunkten und Prüfpunkten eines Prüflings gegeben ist.

Weitere Ausführungsformen der Prüfvorrichtung ergeben sich aus den übrigen Unteransprüchen.

Unter dem Ausdruck "Halbleiterbasis" ist verstanden, daß die Platte nur aus einem Halbleiter besteht oder auch noch zusätzliche Komponenten oder dergleichen, beispielsweise Dotierungen, metallische Beschichtungen usw., aufweisen kann. Der Halbleiter kann ein Elementenhalbleiter (ein Elementenhalbleiter besteht aus einem einzigen chemischen Element, beispielsweise aus Silizium) oder ein Verbindungshalbleiter (brit.: compound semiconductor; ein Verbindungshalbleiter enthält mehrere chemische Elemente, z.B. GaAS) oder ein sonstiger Halbleiter sein.

Indem die an einer auf Halbleiterbasis hergestellten Platte vorgesehenen Tastpunkte, vorzugsweise alle Tastpunkte von metallischen Kontaktnadeln gebildet sind, können dies Tastpunkte extrem kleine Mittenabstände voneinander haben und so in bisher nicht entfernt erreichbarer Dichte (Dichte = Anzahl der Tastpunkte pro Flächeneinheit) angeordnet sein. Hierdurch sind hohe Dichten der Tastpunkte mit entsprechend dünnen Kontaktnadeln erreichbar, da durch Widerlager an der auf Halbleiterbasis hergestellten Platte, die im folgenden als H-Platte bezeichnet wird,
kleinere Mittenabstände benachbarter Kontaktnadeln als bei bekannten Prüfvorrichtungen mit Kontaktnadeln möglich sind. Auch ist es möglich, an einer Prüfvorrichtung sowohl Kontaktnadeln als auch durch die oder mindestens eine H-Platte gebildete Tastpunkte vorzusehen, um so bspw. Prüflinge auf einfache Weise prüfen zu können, bei denen zuerst eine Prüfung mittels nur durch Kontaktnadeln kontaktierten Stellen durchgeführt wird und dann der Prüfling näher an die mindestens eine H-Platte herangeführt wird, so daß nunmehr auch an ihr vorgesehene Tastpunkte an einer zweiten Prüfung zusammen mit den Kontaktnadeln mitwirken können. Es ist jedoch möglich und in vielen Fällen vorteilhaft, die Tastpunkte der Prüfvorrichtung entweder nur an ihrer mindestens einen H-Platte oder nur an Kontaktnadeln vorzusehen.

Die Prüfvorrichtung kann zweckmäßig eine die elektrische Prüfung des jeweiligen Prüflings durchführendes Prüfschaltung aufweisen, die Schaltmittel zum elektrischen Anschließen von Tastpunkten der Prüfvorrichtung an die Prüfschaltung aufweist, wobei bei der Prüfung eines Prüflings zwischen Tastpunkten der Prüfvorrichtung und ihnen gegenüber befindlichen Prüfpunkten des Prüflings von der Prüfschaltung bewirkbare Prüfsignale übertragbar sind, die in der Prüfschaltung daraufhin auswertbar sind, ob der Prüfling elektrisch fehlerfrei ist oder nicht. Diese Prüfschaltung der Prüfvorrichtung kann vorzugsweise mindestens teilweise, oft zweckmäßig ganz oder im wesentlichen in die mindestens eine H-Platte integriert sein. Die H-Platte kann aus einem einzigen Bauelement bestehen, vorzugsweise aus einem Wafer oder einem Chip. Sie kann jedoch auch aus mehreren Bauelementen zusammengesetzt sein, vorzugsweise aus mehreren Wafern oder Chips, die zu der H-Platte zusammengesetzt sind, bspw. durch Kleben praktisch abstandslos miteinander verbunden oder auf einer gemeinsamen Fläche eines Trägers angeordnet und zu der H-Platte direkt oder über die sie tragende Fläche miteinander verbunden sind. Es ist in vielen Fällen auch zweckmäßig, daß die Prüfvorrichtung mindestens zwei H-Platten aufweist, die in Abständen voneinander in einer Tragvorrichtung angeordnet sind, bspw. dann, wenn durch die Prüfvorrichtung jeweils simultan mehrere Prüflinge geprüft werden sollen, wobei dann jedem der gleichzeitig zu prüfenden Prüflinge jeweils eine H-Platte der Prüfvorrichtung zugeordnet ist. Oder es kann auch vorgesehen sein, daß im Falle von Prüflingen, deren Prüfpunkte auf Felder verteilt sind, die zwischen sich nicht unerhebliche Abstände haben, dann jedem solchen Feld oder Gruppen von Feldern je eine H-Platte der Prüfvorrichtung für die Prüfung zugeordnet wird.

Wenn die H-Platte als Chip ausgebildet ist, kann sie bspw. die Größe eines Wafers haben. Man könnte sie dann zumindest in vielen Fällen auch als Riesenchip bezeichnen.

Auch kann die Prüfvorrichtung kostengünstig herstellbar sein und extrem viele Tastpunkte aufweisen. Vorteilhaft kann sie viele Tausende von Tastpunkten, insbesondere Hunderttausende oder Millionen oder sogar viele Millionen von Tastpunkten erhalten. Die Kosten der Prüfvorrichtung pro Tastpunkt sind oder können erheblich niedriger sein als die Kosten herkömmlicher Prüfvorrichtungen. Auch ist die erfindungsgemäße Prüfvorrichtung weniger störanfällig und kann baulich kleiner und kompakter als herkömmliche Prüfvorrichtungen ausgebildet sein und eröffnet auch neue Möglichkeiten der Prüfung von Prüflingen.

So kann oft zweckmäßig zusätzlich zu dem Kontaktieren von Prüfpunkten durch Tastpunkte vorgesehen sein, daß alle oder eine Teilanzahl der Prüfpunkte von Prüflingen durch Tastpunkte der Prüfvorrichtung berührungslos getastet werden, worunter verstanden ist, daß den betreffenden Prüfpunkten die Prüfsignale von den ihnen im Abstand gegenüberstehenden Tastpunkten berührungslos übermittelt und an den zugeordneten Tastpunkten von den Prüfpunkten berührungslos empfangen werden können. Dabei ist es vorgesehen, einen Pad, einen Endbereich einer Leiterbahn oder eine sonstige Stelle eines Prüflings nicht mehr wie bisher durch jeweils einen einzigen Tastpunkt zu kontaktieren, sondern mehrfach oder vielfach durch Tastpunkte gleichzeitig zu kontaktieren oder berührungslos zu tasten, also entsprechend viele Prüfpunkte an der betreffenden Stelle des Prüflings vorzusehen und hierdurch die Sicherheit der Prüfung zu erhöhen.

Auch können neue Prüfungsgebiete erschlossen werden, wie sie bisher der Prüfung durch Kontaktstifte aufweisende herkömmliche Prüfvorrichtungen nicht zugänglich waren, u.a. können stärker miniaturisierte und höher integrierte Mikroelektroniken ebenfalls durch erfindungsgemäße Prüfvorrichtungen auf einfache Weise geprüft werden, die der Prüfung durch die bisherigen, Kontaktstifte aufweisenden Prüfvorrichtungen nicht zugänglich waren. Auch können die Tastpunkte in so engem Raster angeordnet sein, daß die den Tastpunkten frei gegenüberliegenden Leiterbahnstrukturen und Pads der Prüflinge rasterartig abgebildet und visuell oder selbsttätig auf Fehlerfreiheit geprüft werden können.

Vorzugsweise kann zumindest die Vorderseite der H-Platte oder mindestens einer H-Platte der Prüfvorrichtung eine mikromechanisch hergestellte Struktur aufweisen, wobei vorzugsweise vorgesehen sein kann, daß die Tastpunkte und/oder die Widerlager für Kontaktnadeln an mikromechanisch hergestellten Strukturen dieser Oberfläche der H-Platte angeordnet oder vorgesehen sind.

Die H-Platte ist so ausgebildet sein, daß sie für einige, besonders zweckmäßig für alle oder fast alle ihr zugeordneten Tastpunkte mindestens je einen Halbleiterbezirk aufweist, der mindestens ein p-Gebiet und/oder mindestens ein n-Gebiet aufweist, welches Gebiet bzw. welche Gebiete vorzugsweise stark dotiert sein können. Unter einem p-Gebiet ist ein durch Dotierung oder auf sonstige Weise erzeugtes, elektrisch leitfähiges Gebiet der H-Platte verstanden, das im Überschuß (Majorität) Löcher positiver Polarität (auch Defektelektronen genannt) aufweist.

Unter einem n-Gebiet ist ein dotiertes oder auf sonstige Weise erzeugtes, elektrisch leitfähiges Gebiet verstanden, das im Überschuß Elektronen aufweist. In diesem Zusammenhang sei auch ausgeführt, daß das Halbleitermaterial der H-Platte bzw. ihrer Bauelemente undotiert oder im Ganzen oder bereichsweise dotiert sein kann.

Die H-Platte oder, wenn sie aus mehreren Bauelementen zusammengesetzt ist, jedes dieser Bauelemente kann vorzugsweise als Einkristall oder auf der Basis eines Einkristalles eines Halbmetalles, also eines Halbleiters, hergestellt sein, sei es in einschichtigem oder mehrschichtigem Aufbau. Vorzugsweise kommen Halbmetalle in Frage, die gute elastische Eigenschaften haben, und zwar sowohl Elementarhalbleiter aus einem einzigen Element (z.B. Si, Ge), als auch Verbindungshalbleiter, die zwei oder mehr Elemente enthalten (z.B. GaAs). Besonders zweckmässig ist Silizium.

In manchen Fällen kann die H-Platte oder mindestens eines ihrer Bauelemente polykristallin oder in Sonderfällen auch amorph auf der Basis von Halbmetall, d.h. auf Halbleiterbasis, hergestellt sein.

Bei bevorzugten Ausführungsformen sind zumindest einige, vorzugsweise alle oder fast alle Tastpunkte bzw. Widerlager an Vorsprüngen der dem jeweiligen Prüfling zugewendeten Vorderseite der mindestens einen H-Platte vorgesehen. Diese Vorsprünge können vorzugsweise auf mikromechanischem Wege hergestellt sein. Sie können vorzugsweise ungefähr zylindrische Gestalten haben mit beispielsweise runden oder eckigen, beispielsweise ungefähr quadratischen Querschnitten oder sie können auch andere Gestalten haben, vorzugsweise auf mindestens einem Teilbereich ihrer Längen sich verjüngen, beispielsweise als Kegelstümpfe, Kegel, Pyramidenstümpfe, Pyramiden oder dergleichen ausgebildet sein.

Mindestens einigen, vorzugsweise allen oder fast allen Tastpunkten kann zweckmäßig ein Bezirk der H-Platte zugeordnet sein, der ein p-Gebiet und/oder ein n-Gebiet aufweist, das am Leiten der durch diesen Tastpunkt Übertragbaren Prüfsignale mitwirkt oder das p-Gebiet bzw. n-Gebiet eines solchen Bezirks kann auch den betreffenden Bezirk selbst bilden. Ein solches Gebiet kann dabei vorzugsweise ein p-Gebiet bzw. n-Gebiet einer in die betreffende H-Platte integrierten elektrischen Komponente sein, insbesondere eines Transistors oder einer Diode, der bzw. die am Schalten, Sperren oder Gleichrichten der dem zugeordneten Tastpunkt von der Prüfschaltung zuleitbaren und von ihm zur Prüfschaltung ableitbaren Prüfsignale dient oder hieran mitwirkt. Eine solche elektronische Komponente ist in die betreffende H-Platte bzw. deren betreffendes Bauelement integriert und bildet so auch eine Komponente der Prüfschaltung selbst.

Wenn die Prüfschaltung ganz oder teilweise in die mindestens eine H-Platte der Prüfvorrichtung integriert ist, können die betreffenden elektronischen Komponenten, Leiterbahnen oder dergleichen an der Vorderseite und/oder an der Rückseite und/oder im Inneren der H-Platte bzw. des oder der betreffenden Bauelemente integriert sein. Elektrische Leiter, wie Leiterbahnen oder dergleichen, können durch metallische Beschichtungen, Durchkontaktierungen oder durch sonstige in der Mikroelektronik anwendbare Maßnahmen gebildet sein. Insbesondere dann, wenn die einzelne H-Platte bzw. jedes ihrer Bauelemente auf der Basis eines Silizium-Einkristalles hergestellt ist, haben mikromechanisch hergestellte Vorsprünge der H-Platte ausgezeichnete federnde Eigenschaften, die denen von Federstahl vergleichbar sind.

Tastpunkte aufweisende Vorsprünge oder dem elektrischen Anschluß von Kontaktnadeln dienende Stellen der H-Platte bzw. ihrer sie bildenden Bauelemente können auch in Form von geraden oder gebogenen Biegefedern, wie federnden Stäben, Blattfedern, federnden Zungen, elastischen Membranen oder dergleichen ausgebildet sein.

An der Prüfung eines Prüflings können je nach Prüfling und Art der Prüfung alle oder nur eine Teilanzahl der Tastpunkte der Prüfvorrichtung teilnehmen durch entsprechende Programmierung der Prüfschaltung. Die Programmierung der Prüfschaltung für eine Serie unter sich gleicher Prüflinge kann beispielsweise im Prinzip wie bei den bekannten Prüfvorrichtungen selbsttätig unter Einsatz eines fehlerfreien Prüflings erfolgen.

Für das zusätzliche berührungslose Senden und Empfangen von Prüfsignalen durch Tastpunkte der Prüfvorrichtung können diese Tastpunkte vorzugsweise als kleine, an der betreffenden H-Platte bzw. des betreffenden Bauelementes von ihr mikromechanisch hergestellte Spulen ausgebildet sein, die so als Sende-Antennen bzw. als Empfangs-Antennen für Prüfsignale dienen. Diese Spulen können so winzig klein sein, beispielsweise maximale Durchmesser von 1 bis 50 Mikrometer aufweisen oder auch noch kleinere oder größere Durchmesser und ihre Abstände vom jeweiligen Prüfling bei dessen Prüfung können so gering gehalten werden, daß die jeweilige Spule, wenn sie mit Wechselstrom oder Impulszügen beschickt wird, nur einen eng begrenzten Prüfpunkt, dessen Durchmesser nicht oder nur wenig größer als der Durchmesser der Spule ist, mit dem von ihr erzeugten elektromagnetischen Feld wirksam beaufschlagt und so hier eine geringe elektrische Spannung an diesem Prüfpunkt induziert, wobei mindestens eine andere solche Spule einer anderen Stelle des betreffenden Leiters des Prüflings im Abstand gegenüberstehen kann und der in diesem elektrischen Leiter induzierte Prüfstrom induziert dann in der betreffenden mindestens einen anderen, als Empfangs-Antenne dienenden Spule derselben oder einer anderen H-Platte einen Prüfstrom oder eine Prüfspannung, die von der Prüfschaltung der Prüfvorrichtung ausgewertet wird.

Der zusätzlichen berührungslosen Übertragung von Prüfsignalen zwischen Tastpunkten und Prüfpunkten können also elektromagnetische Felder dienen. Es ist jedoch auch denkbar und möglich, hierfür auch andere Maßnahmen vorzusehen, beispielsweise kapazitive Kopplung zwischen je einem Tastpunkt und einem im Abstand gegenüberstehenden Prüfpunkt des jeweiligen Prüflings oder durch Übertragung von Ladungsträgern zwischen einem Tastpunkt und einem Prüfpunkt, wie Ionen oder Elektronen, beispielsweise durch Spitzenentladungen mittels an der mindestens einen H-Platte mikromechanisch hergestellten, halbleitenden oder metallisch beschichteten Spitzen.

Wenn Tastpunkte durch die vorderen Enden von Kontaktnadeln gebildet sind, können diese Kontaktnadeln elektrisch leitfähige p-Gebiete und n-Gebiete der mindestens einen H-Platte zu ihrem elektrischen Anschluß kontaktieren.

Die Konktaktnadeln können insbesondere gebogene Nadeln, gerade Starrstifte oder sogenannte Knicknadeln sein. Unter einer Knicknadel ist eine gerade Nadel verstanden, die bei ausreichend großer axialer Kraft auf ihr freies, den Prüfling kontaktierendes Ende ausknickt und so axial federnd wirkt.

Bevorzugt können die Tastpunkte der Prüfvorrichtung in so engem Raster angeordnet sein, daß die Prüfvorrichtung zur Prüfung unterschiedlich großer Prüflinge bis zu einer maximalen Prüflingsgröße eingesetzt werden kann. Die Dichte der Tastpunkte kann dabei so groß sein, daß sich auf der den Tastpunkten gegenüberliegenden Oberfläche des Prüflings vorhandene Leiterstrukturen erkennen lassen, so daß man praktisch ein Abbild, das gewünschtenfalls auch digital gespeichert werden kann, der jeweiligen Leiterstruktur des Prüfling auf dessen den Tastpunkten der Prüfvorrichtung gegenüberliegenden Fläche erhalten kann und mit einem Soll-Bild der Leiterstruktur visuell oder selbsttätig vergleichen kann und so aus dem Vergleich ermitteln kann, ob der betreffende Prüfling bezüglich dieser abgebildeten Leiterstruktur fehlerfrei oder fehlerhaft ist. Diese Abbildungsmethode eignet sich besonders für unbestückte, nur oberflächig mit Leiterbahnen oder dgl. beschichtete Leiterplatten oder für einschichtige Chips, jedoch kommt diese Abbildungsmethode auch für andere Prüflinge ebenfalls in Frage. Dies ergibt auch größere Toleranzen der Lage des Prüflings zu den Tastpunkten und es kann gewünschtenfalls jeder Prüfling auf seine Lage relativ zum Feld der Tastpunkte ermittelt und rechnerisch die Prüfschaltung auf die Lage des einzelnen Prüflings jeweils umprogrammiert werden, so daß diese Relativlage unkritisch ist. Dies geht auch dann, wenn kein Bild der Leiterstruktur gewonnen wird, sondern nur Ausschnitte der Leiterstruktur. Beispielsweise können auf jedem Prüfling ein oder mehrere Punkte angeordnet sein, deren Lage durch eine Optik, durch mindestens einen Tastpunkt oder durch sonstige, bspw. elektrische Mittel nach ihren Koordinaten ermittelt werden. Der Rechner rechnet das Prüfprogramm für den betreffenden Prüfling nach diesen Koordinaten um, falls diese Koordinaten von den Soll-Koordinaten abweichen.

Die erfindungsgemäßen Prüfvorrichtungen können mit besonderem Vorteil der Prüfung unbestückter Leiterplatten und von Chips mit sehr kleinen Pads dienen. Sie können jedoch auch dem Prüfen anderer elektrischer oder elektronischer Prüflinge dienen, beispielsweise auch dem Prüfen bestückter Leiterplatten.

Wie erwähnt, kann die jeweilige H-Platte einschichtig oder mehrschichtig hergestellt sein, bzw. das sie bildende Halbleitermaterial kann einschichtig bzw. mehrschichtig sein, wobei in letzterem Fall man sie dann als Multilayerplatte bzw. Multilayerbauelement bezeichnen kann. Diese Bauelemente bzw. diese H-Platte kann man auch als Halbleiter-Bauelemente bzw. Halbleiterplatte bezeichnen, unabhängig davon, ob in sie Schaltkreise integriert sind und ob sie metallische Beschichtungen für Leiterbahnen, isolierende Schichten oder dergleichen und Durchkontaktierungen und dgl. aufweist oder nicht und unbestückt ist oder nicht. Leiterbahnen und Kontaktierungen können beispielsweise aus Aluminium, Gold oder sonstigen geeigneten Metallen bestehen, die in üblichen Verfahren aufgebracht werden können.

Wenn vorstehend von der mikromechanischen Herstellung von Oberflächenstrukturen der H-Platte oder ihrer Bauelemente gesprochen ist, so sei darauf hingewiesen, daß der Begriff "Mikromechanik" dem Fachmann bekannt ist. Es sei bspw. auf das Fachbuch HEUBERGER "Mikromechnik", Springer-Verlag Berlin Heidelberg New York London Paris Tokyo 1989, hingewiesen, in dem auch verschiedene mikromechanische Herstellungsverfahren beschrieben sind.

In der Zeichnung sind Ausführungsbeispiele der Erfindung dargestellt. Es zeigen:
- Fig. 1: eine ausschnittweise Seitenansicht einer Prüfvorrichtung gemäß einem Ausführungsbeispiel der Erfindung in gebrochener und teilweise geschnittener Darstellung, wobei ein Prüfling und der ihn tragende Träger strichpunktiert mit angedeutet sind,
- Fig. 2A: eine ausschnittsweise Draufsicht auf die H-Platte nach Fig. 1, wobei nur die Vorsprünge dargestellt und die Leiterbahnen weggelassen sind,
- Fig. 2B und 2C: Untenansichten von Platten der Prüfvorrichtung nach Fig. 1,
- Fig. 2D: eine schaubildliche Schrägansicht eines kleinen Ausschnittes der H-Platte nach Fig. 2A, welcher nur einen einzigen Vorsprung zeigt, wobei schematisch die von dem p-Gebiet und dem n-Gebiet des Vorsprunges mitgebildete Transistoren und ihre elektrischen Leiterbahnanschlüsse mit dargestellt sind,
- Fig. 2E: einen Teilschnitt durch die H-Platte nach Fig. 1 in vergrößerter Darstellung,
- Fig. 3: eine ausschnittsweise Draufsicht auf eine H-Platte, wobei eine durch sie kontaktierte Leiterbahn eines Prüflings strichpunktiert mit eingezeichnet ist,
- Fig. 4: eine ausschnittsweise Draufsicht auf eine H-Platte, wobei nur diejenigen Tastpunkte (Vorsprünge) mit eingezeichnet sind, die über die strichpunktiert eingezeichneten Leiterbahnen eines Prüflings kurzgeschlossen sind, um die Möglichkeit der rastermäßigen Abbildung solcher Leiterbahnen eines Prüflings durch die Prüfvorrichtung darzustellen,
- Fig. 6: eine ausschnittsweise Draufsicht auf eine H-Platte gemäß einem Ausführungsbeispiel der Erfindung,
- Fig. 10: eine ausschnittsweise Draufsicht auf eine H-Platte, wobei einige in sie integrierte Schaltungen durch Schaltsymbole angedeutet sind,
- Fig. 11: einen Teilschnitt durch die H-Platte nach Fig. 10 gesehen entlang der Schnittlinie 11-11, wobei auch ein Prüfling ausschnittsweise mit dargestellt ist,
- Fig. 12: einen Schnitt durch Fig. 11 gesehen entlang der Schnittlinie 12-12,
- Fig. 13: eine ausschnittsweise Draufsicht auf die H-Platte nach Fig. 2A, wobei hier nur ein einzelner Vorsprung dargestellt ist und an sein p-Gebiet und n-Gebiet angeschlossene, in die H-Platte integrierte Schaltungen ausschnittsweise durch elektrische Symbole symbolisiert mit eingezeichnet sind,
- Fig. 14: eine teilweise geschnittene Seitenansicht einer Kontaktnadeln aufweisenden Prüfvorrichtung zum Prüfen eines in Seitenansicht dargestellten Prüflings, wobei die Kontaktnadeln auf einer H-Platte abgestützt sind und Mittel zum Spannen der Kontaktnadeln schematisch und teilweise geschnitten mit dargestellt sind,
- Fig. 15: einen Ausschnitt aus Fig. 14 in vergrösserter Darstellung,
- Fig. 16A: eine Variante der Prüfvorrichtung nach Fig. 14 in ausschnittsweiser geschnittener Seitenansicht.
- Fig. 16B,: einen Schnitt durch einen Vorsprung der H-Platte der Fig. 16A in vergrößerter Darstellung, und
- Fig. 17: Prinzipschaltung für die Ansteuerung einer Prüfzelle.

Zunächst sei dargelegt, daß in einigen der Figuren, jedoch nicht in allen Figuren, p-Gebiete durch eingezeichnete kleine Kreise und n-Gebiete durch eingezeichnete Punkte symbolisiert sind. Die kleinen Kreise sollen die in Majorität vorliegenden Löcher (Defektelektronen) und die Punkte die in Majorität vorliegenden Elektronen symbolisieren.

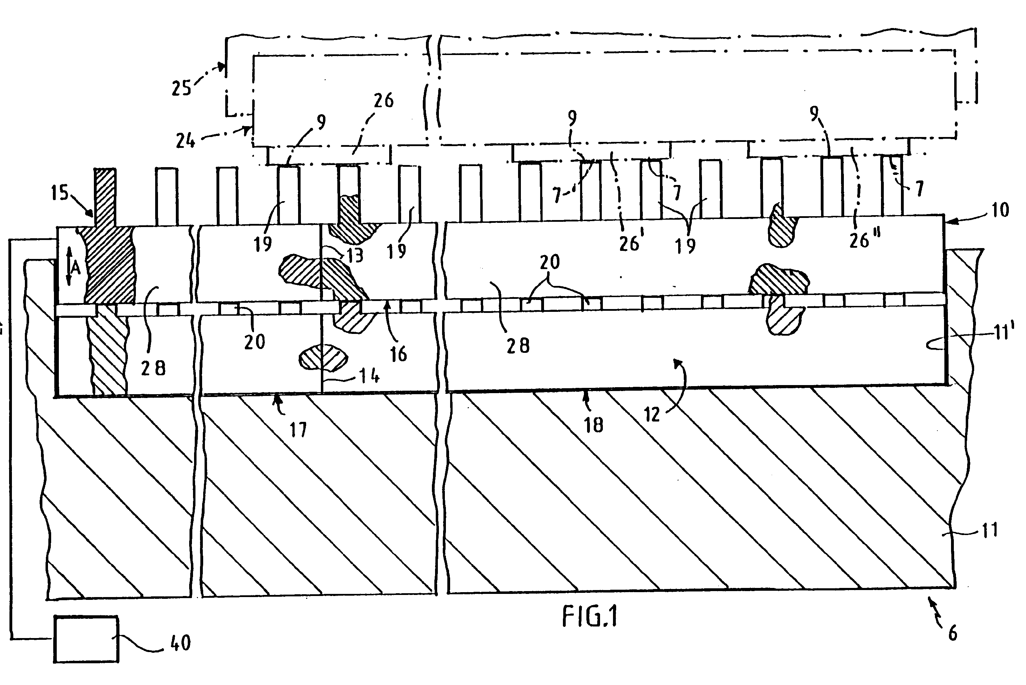

Die in Fig. 1 teilweise geschnitten und gebrochen und ausschnittsweise dargestellte und teilweise auch nur strichpunktiert angedeutete Prüfvorrichtung 6 weist eine auf Halbleiterbasis hergestellte Platte 10 - nachfolgend auch H-Platte genannt - auf, die auf einer in einem Träger 11 fest angeordneten, ebenfalls auf Halbleiterbasis hergestellten Platte 12 mit ihrer ebenen Unterseite aufsitzt. Diese beiden Platten 10 und 12 sind in einer Ausnehmung 11′ des Trägers 11 formschlüssig gehalten, wobei die Platte 10 sich in der Ausnehmung 11′ des Trägers 11 mit Gleitlagersitz vertikal in Richtung des Doppelpfeiles A auf- und abwärts bewegen kann.

Beide Platten 10 und 12 sind jeweils aus mehreren plattenförmigen Bauelementen 15, 16 bzw. 17, 18 zusammengesetzt, die an ihren Stoßfugen 13 und 14 fest miteinander verbunden sind, beispielsweise durch Laserschweißen.

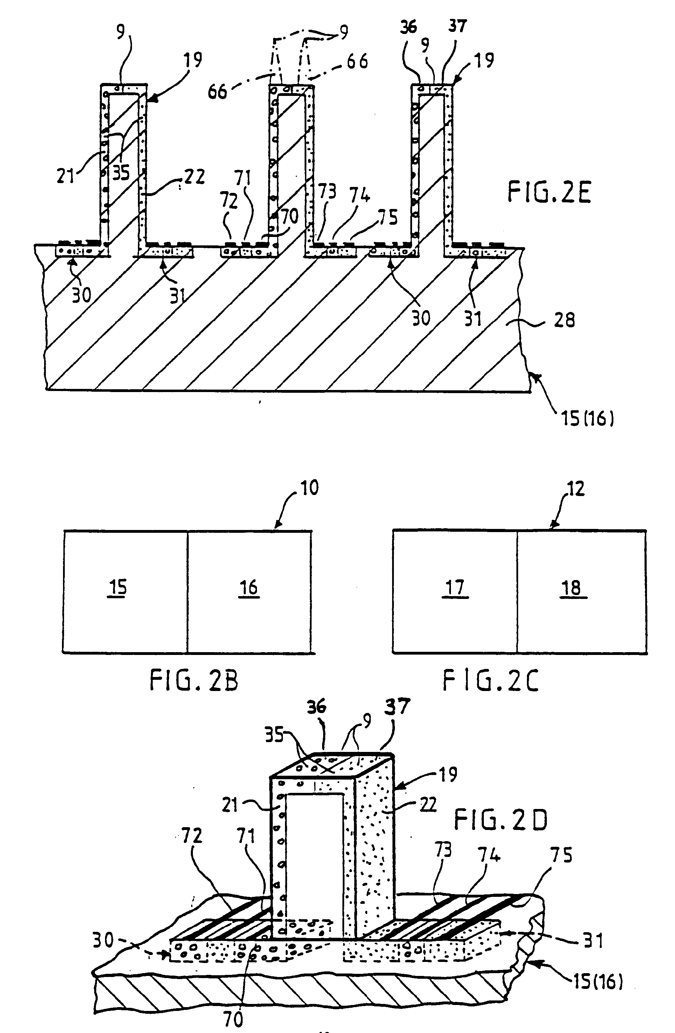

Beispielsweise können diese Platten 10 und 12 gemäß ihren in den Fig. 2B und 2C dargestellten Untenansichten aus je zwei gleich großen rechteckförmigen Bauelementen 15, 16 bzw. 17, 18 zu der entsprechend größeren ebenfalls rechteckförmigen Platte 10 bzw. 12 zusammengesetzt sein. Gegebenenfalls kann die Platte 10 wie auch die Platte 12 aus je einem einzigen, sie bildenden Bauelement oder aus mehr als zwei zu ihr zusammengesetzten Bauelementen bestehen.

Im weiteren sei für die Beschreibung angenommen, daß diese beiden Platten 10 und 12 aus den jeweils beiden Bauelementen 15, 16 bzw.17, 18 zusammengesetzt sind.

Diese ebenfalls plattenförmigen Bauelemente 15, 16, 17 und 18 können aus je einer einkristallinen (monokristallinen) Scheibe eines Halbmetalls, d.h. auf der Basis eines Halbleiters in nachfolgend noch näher beschriebenen Weise hergestellt sein. Man kann sie deshalb auch als Halbleiter-Bauelemente bezeichnen, gleichgültig ob in sie elektronische Komponenten, wie Schaltkreise, Transistoren, Widerstände oder dgl. und durch Beschichten oder auf sonstige Weise metallische Leiterbahnen, Kontaktflächen oder sonstige mikroelektronische Komponenten integriert sind oder nicht. An diese Bauelemente 15 bis 18 können noch Teile, wie bspw. elektrische und mechanische Komponenten, z. B. Stecker, Buchsen, IC-Chips der Prüfschaltung oder dgl. angefügt sein.

Die Bauelemente 15 und 16 können unter sich gleich ausgebildet sein und bilden Module, aus denen die H-Platte 10 zusammengesetzt ist. Desgleichen bilden die Bauelemente 17, 18 ebenfalls Module, aus denen die Platte 12 zusammengesetzt ist.

Jedes der Bauelemente 15, 16, 17 und 18 ist also auf Halbleiterbasis hergestellt, vorzugsweise jeweils aus einem einzigen Einkristall, der vorzugsweise ein Silizium-Einkristall sein kann, gegebenenfalls jedoch auch ein anderer Halbleiter, vorzugsweise ebenfalls ein Einkristall. Auch andere geeignete Halbleiter kommen in Frage.

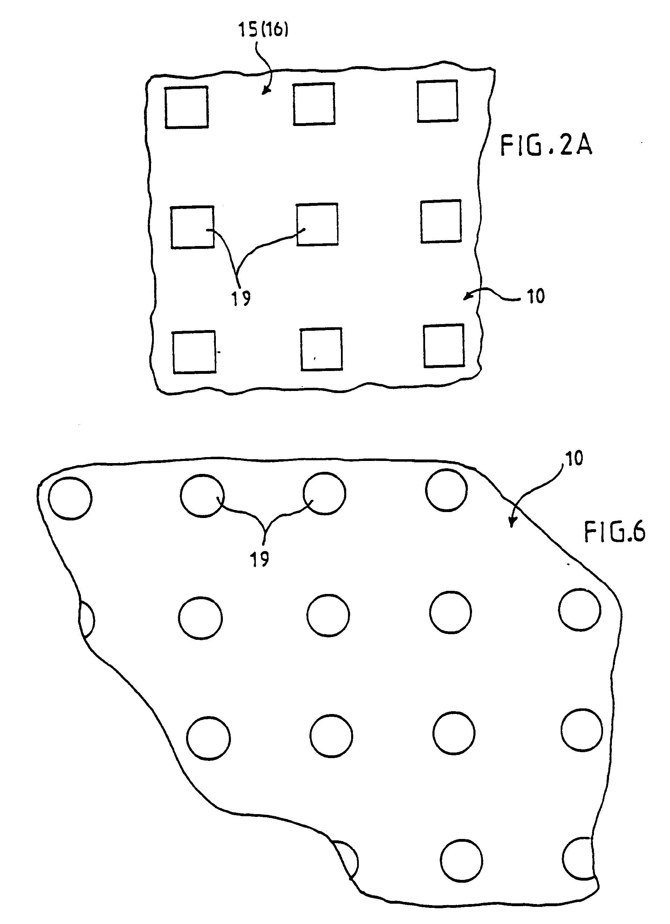

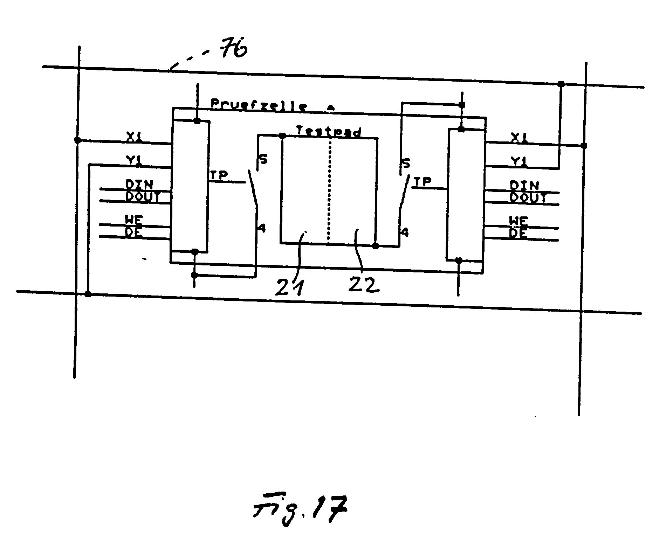

Jedes Bauelement 15, 16, 17 und 18 weist in sich entsprechenden Rastern auf seiner nach oben gerichteten Vorderseite angeordnete und senkrecht zur jeweiligen Plattenebene gerichtete, ungefähr zylindrische Vorsprünge 19 (Bauelemente 15 und 16) bzw. 20 (Bauelemente 17 bzw. 18) auf. Diese Vorsprünge sind aus der betreffenden einkristallinen, ursprünglich konstante Dicke aufweisenden Scheibe mikromechanisch hergestellt, bspw. durch Ätzen. Gemäß Fig. 2A haben diese Vorsprünge quadratischen Querschnitt, doch kommen auch andere Querschnitte in Frage, beispielsweise gemäß Fig. 6 runde Querschnitte, vorzugsweise kreisrunde Querschnitte.

Die Vorsprünge 19 und 20 haben in diesem Ausführungsbeispiel gleiche Querschnitte, doch sind die Vorsprünge 19 in diesem Ausführungsbeispiel wesentlich länger als die unter ihnen an der Platte 12 vorhandenen Vorsprünge 20.

Nach der mikromechanischen Herstellung der strukturierten Vorderseiten dieser Bauelemente 15, 16, 17 und 18 können sie noch mikroelektronischen Behandlungen zur Herstellung elektronischer Komponenten, Schaltkreisen und dgl. unterworfen werden und auch mit metallischen Beschichtungen, wie Leiterbahnen oder dgl. und Durchkontaktierungen versehen werden oder auch schon vor der mikromechanischen Behandlung einen vorzugsweise einkristallinen schichtweisen (multilayer) Aufbau mit in den Schichten integrierten elektronischen Komponenten, wie Schaltkreisen und dgl. erhalten haben, einschließlich des Aufbringens metallischer Leiterbahnen und sonstiger metallischer Beschichtungen. Solche Beschichtungen können bspw. aus Aluminium, Gold oder dgl. bestehen.

In diesem Ausführungsbeispiel sind die Vorsprünge 19 der H-Platte 10 so dotiert, daß jeder Vorsprung 19 gemäß den Fig. 2D und 2E je ein p-Gebiet 21 und n-Gebiet 22 aufweist, die zusammen einen Halbleiterbezirk 35 bilden, der einen Tastpunkt 9 aufweist, der durch die durch die beiden Gebiete 21, 22 je zur Hälfte gebildeten Stirnfläche des Vorsprunges 19 gebildet ist. Die beiden Hälften des stirnseitigen Testpunktes 9 bilden so je ein linkes Pad 36 und rechtes Pad 37. Diese seien im weiteren "Testpads" genannt. Die Gebiete 21 und 22 führen von der Stirnseite des Vorsprungs 19, d.h. den Testpads 36, 37 entlang zwei voneinander abgewendeten Seitenwänden des Vorsprunges 19 bis in den Hauptbereich 28 des betreffenden Bauelementes 15 bzw. 16. Unter diesem Hauptbereich 28 ist der Bereich des betreffenden Bauelementes 15 bzw. 16 verstanden, von dem die Vorsprünge 19 in einstückiger Verbindung mit ihm vorspringen, so daß also dieser Hauptbereich 28 das betreffende Bauelement 15 bzw. 16, das man auch als Halbleiter-Bauelement bezeichnen kann, mit Ausnahme seiner Vorsprünge bildet.

Die p- und n-Gebiete 21 und 22 können vorzugsweise stark dotiert sein. Wie in den Fig. 2D und 2E dargestellt, bilden die Gebiete 21, 22 je ein dotiertes Gebiet je eines in dieses Bauelement 15 bzw. 16 integrierten Schalttransistors 30 und 31. Die Leiterbahnanschlüsse 70 bis 75 dieser Transistoren 30 und 31 sind in Fig. 2D geschnitten und in Fig. 2E ausschnittsweise dargestellt.

Die Durchmesser der Vorsprünge 19, wie auch die der Vorsprünge 20 können zweckmäßig sehr klein sein, vorzugsweise 2 bis 50 Mikrometer betragen, je nach Erfordernis auch noch kleiner oder auch größer sein.

Ein solches Bauelement kann eine extrem große Anzahl solcher Vorsprünge 19 bzw. 20 aufweisen, vorzugsweise viele Tausende bis mehrere oder viele Millionen solcher Vorsprünge 19 bzw. 20. Anstatt jeden Tastpunkt 9 eines Vorsprungs 19 durch eine einzige Fläche - hier durch die ebene Stirnfläche des Vorsprunges 19 zu bilden, kann der Tastpunkt 9 auch durch mehrere Stellen des Vorsprungs gebildet sein, bspw. durch die Spitzen mehrerer Zacken 66, wie es in Fig. 2E strichpunktiert angedeutet ist, oder durch mehrere sonstige Erhöhungen gebildet sein.

Die Vorsprünge 20 der Bauelemente 17 und 18 sind vertikal unterhalb den Vorsprüngen 19 der Bauelemente 15 und 16 angeordnet, um die von dem jeweiligen Prüfling auf Vorsprünge 19 ausgeübte axiale Kontaktkräfte axial abzustützen. Die Vorsprünge 20 der Bauelemente 17 und 18 ermöglichen es dabei, daß diese Bauelemente zwischen den Vorsprüngen 20 und seitlich von ihnen mit Leiterbahnen beschichtet sein können und desgleichen können in diese Bauelemente 17, 18 mikroelektronisch hergestellte elektronische Komponenten, wie Dioden, Transistoren, Schaltkreise und dergleichen integriert sein, die Teile der Prüfschaltung bilden können. Wenn dies nicht notwendig ist, können die Bauelemente 17 und 18, das heißt die Platte 12, entfallen und die H-Platte 10 direkt auf dem Boden der dann entsprechend flacher ausgebildeten Ausnehmung 11′ des Trägers 11 aufsitzen, wobei gegebenenfalls in diesem Fall oft zweckmäßig auch vorgesehen sein kann, daß an den quaderähnlichen Hauptbereichen 28 der Bauelemente 15, 16 der H-Platte 10 untenseitig Vorsprünge angeordnet sein können, die ebenfalls mikromechanisch hergestellt sind und mit denen diese H-Platte 10 auf dem Boden der Ausnehmung 11′ aufsitzt, um so auch untenseitig an der H-Platte durch Beschichten hergestellte Leiterbahnen und beliebige elektronische, in das Hauptgebiet integrierte Schaltkreise und sonstige elektronische Komponenten vorsehen zu können, die Teile der Prüfschaltung bilden.

Das Halbleitermaterial, aus dem die Bauelemente 15 bis 18 hergestellt sind, ist elastisch, so daß entsprechend die Vorsprünge 19 und auch die Vorsprünge 20 axial elastisch sind. Dies ermöglicht es, daß alle Prüfpunkte eines zu prüfenden Prüflings, wobei ein solcher Prüfling in Fig. 1 strichpunktiert bei 24 dargestellt ist, durch Vorsprünge 19 der H-Platte 10 mit ausreichender Kraft kontaktiert werden. Falls die Elastizität des Vorsprunges zu gering ist, kann man den Vorsprung an einem elastischen Teil oder Bereich der H-Platte 10 bzw. des betreffenden Bauelementes 15, 16 anordnen, bspw. an einer federnden Zunge, einer elastischen Membrane oder dergleichen. Dieser Prüfling 24 ist zum Kontaktieren der H-Platte 10 an einem vertikal auf und ab bewegbaren Träger 25 der Prüfvorrichtung 10 gehalten und abgestützt, welcher durch einen nicht dargestellten Hubmechanismus auf und ab bewegbar ist und durch den Prüfling 24 mit einstellbarer Kraft an die ihm gegenüberstehenden Vorsprünge 19 der H-Platte 10 andrückbar ist, um so zu bewirken, daß diese betreffenden Vorsprünge 19 mit ihren Tastpunkte 9 bildenden Stirnseiten die zugeordneten Prüfpunkte 7 des Prüflings 24 elektrisch kontaktieren.

Indem jeder Tastpunkt 9 in diesem Ausführungsbeispiel je ungefähr zur Hälfte eine Fläche des betreffenden p-Gebietes 21 und eine Fläche des n-Gebietes 22 ist, ermöglicht jeder Vorsprung 19 das Leiten von positiven und negativen Prüfsignalen, d.h. hier von positiven und negativen elektrischen Strömen und Spannungen, wobei die Transistoren 30, 31 dem Zuschalten und Abschalten der sie mit bildenden p- und n-Gebiete 21, 22 an die bzw. von der übrigen Prüfschaltung dienen.

Die H-Platte 10 kann so groß sein, daß auf ihr Prüflinge unterschiedlicher Größe bis zu Prüflingen einer Maximalgröße geprüft werden können. Dies ist in diesem Ausführungsbeispiel nach Fig. 1 dadurch angedeutet, indem der Prüfling 24 kleiner dargestellt ist, als der H-Platte 10 entspricht, und es können also auch Prüflinge geprüft werden, die noch größer als der dargestellte Prüfling 24 sind oder auch kleiner als dieser Prüfling 24. Auch brauchen nicht alle einem Prüfling 24 gegenüberstehenden Vorsprünge 19 an dessen Prüfung mitzuwirken, sondern es kann vorgesehen sein, daß nur eine Teilanzahl der jeweils einem Prüfling 24 gegenüberstehenden Vorsprünge 19 vorbestimmten Prüfpunkten des Prüflings 24 zu deren elektrischem Anschluß an die Prüfschaltung dieser Prüfvorrichtung angeschlossen werden.

Dies ist in Fig. 1 schematisch dadurch dargestellt, indem der von dem Prüfling 24 dargestellte Ausschnitt drei durch Vorsprünge 19 zu kontaktierende Leiterbahnen 26, 26′ und 26˝ aufweist. Die Leiterbahn 26 wird im dargestellten Schnitt durch zwei der dargestellten Vorsprünge 19, der Leiterbahn 26′ durch drei der dargestellten Vorsprünge 19 und die Leiterbahn 26˝ auch durch drei der dargestellten Vorsprünge 19 kontaktiert. Jede diese Leiterbahnen kann noch durch weitere vor und hinter der Schnittebene angeordnete Vorsprünge kontaktiert werden, wobei die Anzahl der Vorsprünge 19, die eine solche Leiterbahn kontaktieren können, wegen der hohen Tastpunktdichte sehr groß sein kann.

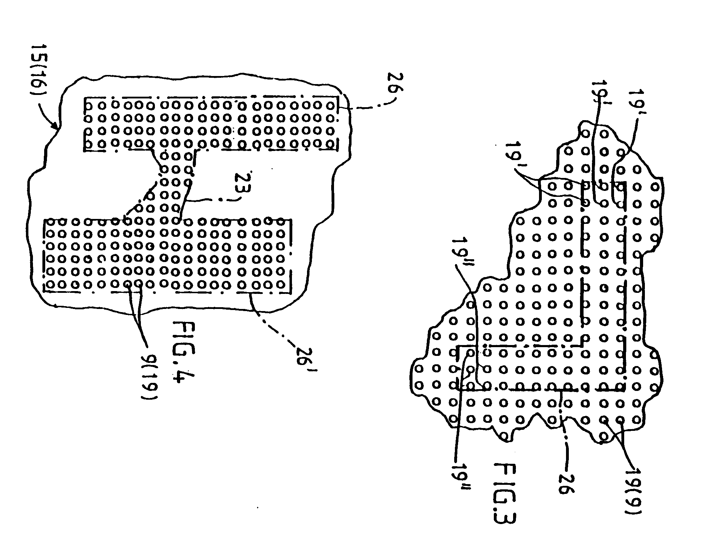

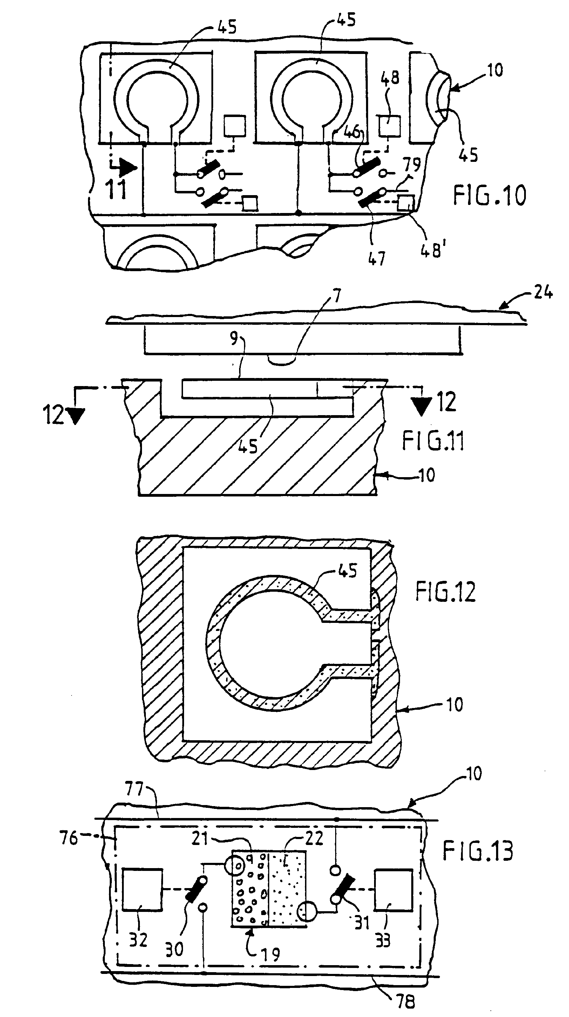

Um die Fehlerfreiheit einer solchen Leiterbahn 26 bzw. 26′ bzw. 26˝ des Prüflings festzustellen, muß jede solche Leiterbahn an ihren beiden Endbereichen durch mindestens je einen Vorsprung 19 kontaktiert werden. Es wird wegen der großen Tastpunktdichte jeder solcher Endbereich durch eine mehr oder weniger große Anzahl solcher Vorsprünge 19, beispielsweise durch zwei bis fünfhundert Vorsprünge 19, kontaktiert, wie es an einem Ausführungsbeispiel in Fig. 3 für die Leiterbahn 26 dargestellt ist. Und zwar ist diese Leiterbahn 26 hier strichpunktiert dargestellt und jeder in dem voll ausgezogen dargestellten Ausschnitt auf der Vorderseite der H-Platte 10 eingezeichnete Kreis entspricht einem Vorsprung 19, wobei diese Vorsprünge 19 in einem engen, rechtwinkligen Raster angeordnet sind, dessen Zeilen gleich große Abstände voneinander haben, die gleich groß sind wie die Abstände der sie rechtwinklig schneidenden Spalten dieses Rasters. Die Tastpunkte 9 sind an den Schnittpunkten dieser Zeilen und Spalten des Rasters angeordnet. Diese Leiterbahn 26 wird hier also von einer großen Anzahl dieser Vorsprünge 19 kontaktiert.

Bei der Prüfung wird die Leiterbahn 26 - wie auch jede andere Leiterbahn - des Prüflings auf Fehlerfreiheit geprüft, d.h. daß sie keine Unterbrechung hat und auch kein Kurzschluß zu anderen Leiterbahnen besteht. Hierzu kann man so vorgehen, daß die Prüfschaltung für den betreffenden Prüfling so programmiert wird, daß durch es nur pro Leiterbahn zwei Tastpunkte 9 einschaltbar sind, also aktivierbar sind und alle anderen die betreffende Leiterbahn kontaktierenden Tastpunkte während der Prüfung dieser Leiterbahn ausgeschaltet, also inaktiv bleiben. Diese beiden aktivierbaren Tastpunkte 9 pro Leiterbahn sind ihren beiden Endbereichen zugeordnete Tastpunkte 9. Das Durchprüfen eines solchen Prüflings kann dann in herkömmlicher Weise erfolgen, wie es bei vorbekannten Prüfvorrichtungen der Fall war, bei denen jede Leiterbahn nur durch je zwei Kontaktstifte an ihren beiden Endbereichen kontaktiert wurde, bspw. nach den US-PS 4,443,756 und 4,528,500.

Die Erfindung schafft jedoch infolge der möglichen hohen Tastpunktdichten weitergehende Möglichkeiten der Prüfung, die die Gefahr von Prüffehlern reduzieren oder ganz beseitigen. Eine dieser Möglichkeiten kann darin bestehen, daß die Prüfschaltung so programmiert wird, daß durch sie von allen jeweils eine Leiterbahn eines Prüflings kontaktierenden Tastpunkte 9 pro Endbereich der betreffenden Leiterbahn jeweils eine Mehrzahl oder Vielzahl von diese Endbereiche kontaktierenden, durch die Stirnflächen der betreffenden Vorsprünge 19 gebildeten Tastpunkte 9 bei der Prüfung eines Prüflings aktivierbar sind. Im Ausführungsbeispiel der Fig. 3 sei angenommen, daß durch die Prüfschaltung von allen die Leiterbahn 26 kontaktierenden Vorsprüngen 19 nur die den einen Endbereich dieser Leiterbahn kontaktierenden sechs Vorsprünge 19′ und die den anderen Endbereich dieser Leiterbahn kontaktierenden sechs Vorsprünge 19˝ im Rahmen eines Prüfzyklus aktivierbar sind. Es wird dann im Rahmen dieses Prüfzyklus durch die Prüfschaltung abgefragt, ob zwischen mindestens einem der Vorsprünge 19′ und mindestens einem der Vorsprünge 19˝ ein elektrischer, durch die Leiterbahn 26 hergestellter Kurzschluß besteht.
Wenn dies für mindestens ein Paar der Vorsprünge 19′/19˝ der Fall ist, dann ist diese Leiterbahn 26 nicht unterbrochen. Die weitere Prüfung hat sich dann darauf zu erstrecken, ob diese Leiterbahn 26 in elektrischem Kurzschluß mit mindestens einer anderen Leiterbahn oder Komponente des Prüflings steht, welcher Kurzschluß nicht sein darf. Diese Prüfung kann so durchgeführt werden, daß die Prüfschaltung prüft, ob irgendeiner der den programmierten Vorsprüngen 19′ bzw. Vorsprüngen 19˝ zugeordneten Prüfpunkte 7 des Prüflings in elektrisch leitender Verbindung, insbesondere im Kurzschluß mit mindestens einem außerhalb der Leiterbahn 26 liegenden Prüfpunkt des Prüflings steht. Ist dies der Fall, dann liegt ein fehlerhafter Kurzschluß vor. Wenn keiner der Vorsprünge 19′ mit einem der Vorsprünge 19˝ kurzgeschlossen ist, dann liegt eine fehlerhafte Unterbrechung der Leiterbahn 26 vor. Solche Fehler können koordinatenmäßig erfaßt werden für eine eventuelle spätere Reparatur.

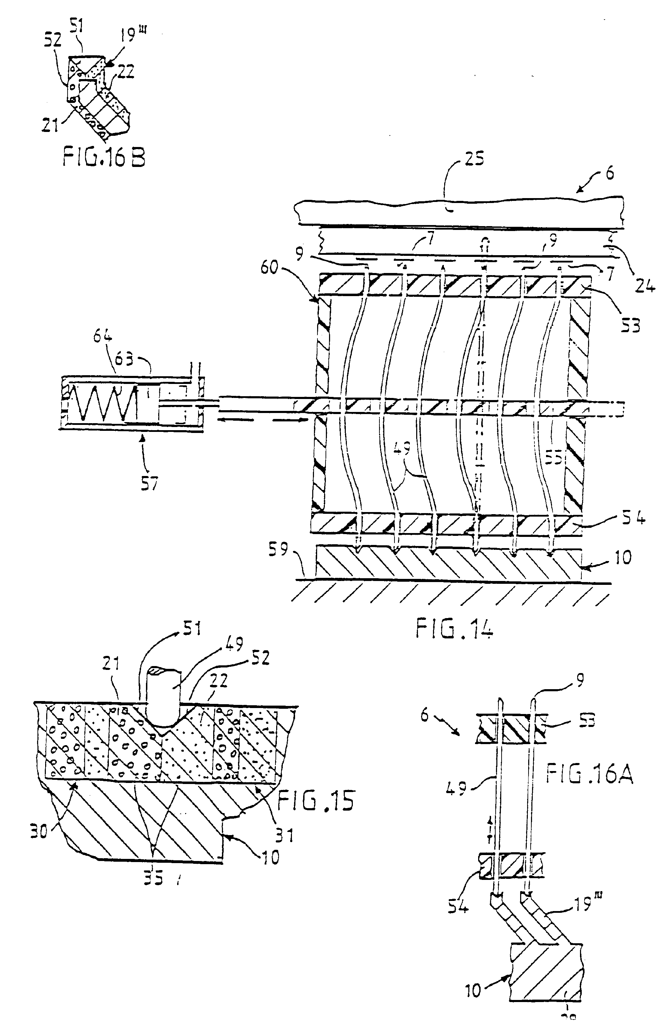

Diese Prüfvorrichtung 6 ermöglicht es auch, wegen der sehr großen Anzahl der Vorsprünge 19 und ihren geringen Mittenabständen voneinander, die also in einem sehr dichten Raster an dessen Rasterpunkten angeordnet sind, wobei das Rastermaß beispielsweise 10 bis 30 Mikrometer oder auch noch kleiner oder auch größer sein kann, eine Abbildung der durch Tastpunkte 9 kontaktierten Leiterbahnen des jeweiligen Prüflings zu erhalten, wenn nämlich alle Vorsprünge 19, die in elektrischem Kurzschluß miteinander durch metallisierte Bereiche des Prüflings stehen, koordinatenmäßig oder bildmäßig erfaßt werden. Fig. 4 zeigt dies an einem Beispiel, wobei alle Vorsprünge 19 und damit ihre Tastpunkte, die durch den Prüfling jeweils miteinander kurzgeschlossen sind, mit den ihnen zugeordneten Werten der betreffenden Koordinaten des Rasters erfaßt werden. Sie können koordinatenmäßig gespeichert und/oder bildmäßig dargestellt werden. In Fig. 4 sind nur die Vorsprünge 19 und damit ihre Tastpunkte 9 dargestellt, die über den Prüfling im Kurzschluß mit anderen Tastpunkten 9 stehen, und man ersieht, daß die beiden hier dargestellten Leiterbahnen 26 und 26′ durch diese Tastpunkte 9 bildlich darstellbar sind. Und zwar ist hier die Darstellung der Leiterbahnen 26 und 26′ so gewählt, daß sie fehlerhaft durch eine metallische Brücke 23 elektrisch leitend verbunden sind, und man erkennt, daß diese fehlerhafte Verbindung auf der Abbildung ebenfalls deutlich zu sehen ist. Die Auswertung einer solchen Abbildung oder der gespeicherten Koordinatenwerte der betreffenden Tastpunkte kann visuell oder auch selbsttätig in einer geeigneten Apparatur, gegebenenfalls durch die Prüfschaltung selbst erfolgen, und zwar durch Vergleich mit einem Soll-Bild.

Die Mehrfach- oder Vielfachabtastung jeder Leiterbahn eines Prüflings und, falls vorhanden, fehlerhafter Kurzschlußverbindungen hat auch den Vorteil, daß, wenn der eine oder andere Prüfpunkt des Prüflings nicht durch den zugeordneten Vorsprung 19 elektrisch kontaktiert oder nicht ausreichend elektrisch kontaktiert wird, beispielsweise zu schwach, daß dann dennoch die Prüfung des Prüflings sicher anzeigt, ob der Prüfling fehlerfrei ist oder tatsächlich eine elektrische Fehlerhaftigkeit vorliegt.

Es ist auch möglich, mit erfindungsgemäßen Prüfvorrichtungen, bspw. mit der nach Fig. 1, auch Prüfungen unter Vornahme zahlenmäßiger oder sonstiger Messungen an Prüflingen vorzunehmen oder mit vorzunehmen, bspw. auch Messungen auf Einhaltung vorbestimmter Toleranzen elektrischer Eigenschaften, um Prüflinge, auch oder nur in solcher Hinsicht auf ihre Fehlerfreiheit zu prüfen. Wenn ein Prüfling bspw. integrierte Schaltkreise, Impedanzen, Kapazitäten oder dgl. aufweist, können die Eigenschaften solcher elektrischer Komponenten oder ihre gesamten oder mindestens eine ihrer Funktionen auf Fehlerfreiheit gemessen und geprüft werden, worunter, wie erwähnt, auch die Einhaltung vorbestimmter Toleranzen, bspw. der Größe von Widerständen oder dgl., mit verstanden ist.

In diesem Zusammenhang sei erläutert, daß die Erfindung auch bezüglich solcher Messungen an Prüflingen hohe Meßgenauigkeiten erreichen läßt, besonders dann, wenn die Prüfschaltung auf kleinem oder engstem Raum mit kurzen Leitungswegen untergebracht ist, vorzugsweise ganz oder im wesentlichen in die mindestens eine H-Platte und/oder in mindestens eine sie stützende Halbleiterplatte integriert ist. Dies ist für die Prüfung von Leiterbahnen von Prüflingen auf Fehlerfreiheit ebenfalls äußerst vorteilhaft.

Anhand der Fig. 13 seien noch unterschiedliche Möglichkeiten des Einschaltens und Abschaltens der Taspunkte 9 der Prüfvorrichtung nach Fig. 1 anhand von einem in Fig. 13 dargestellten Ausführungsbeispiel für einen einzelnen Vorsprung 19 nachfolgend kurz beschrieben. An diesen Vorsprung 19 (wie auch an allen anderen nicht dargestellten Vorsprüngen 19 der betreffenden H-Platte) sind zwei elektronische Schalter 30, 31 angeschlossen, bei denen es sich um die in Fig. 2E dargestellten Transistoren 30, 31 handeln kann, die also in die H-Platte 10 integriert sind und in Fig. 13 durch ihre Schaltsymbole symbolisch dargestellt sind. Der Schalter 30 ist an das stark p-dotierte Gebiet 21 und der Schalter 31 an das stark n-dotierte Gebiet 22 dieses Vorsprunges 19 angeschlossen, wobei diese Gebiete 21, 22 gleichzeitig Gebiete der Transistoren 30 und 31 bilden. Der Schalter 30 ist an eine nur ihm zugeordnete Steuerkomponente 32 und der Schalter 31 an die nur ihm zugeordnete Steuerkomponente 33 angeschlossen. Beide Steuerkomponenten 32, 33 können ebenfalls in die H-Platte 10 integriert sein und bspw. als Register oder modifiziertes Register ausgebildet sein. Der Vorsprung 19, die elektronischen Schalter 30 und 31 und die zugeordneten Steuerkomponenten 32 und 33 bilden eine durch strichpunktierte Umrandung angedeutete Prüfzelle 76.

Die H-Platte 10 weist also eine der Anzahl ihrer Vorsprünge 19 entsprechende Anzahl solcher in sie integrierten Prüfzellen 76 auf, da jedem Vorsprung 19 eine solche Prüfzelle 76 zugeordnet ist. Die Kantenlänge einer solchen Prüfzelle kann bspw. im Bereich von 5 bis 50 Mikrometer liegen, jedoch auch noch kleiner oder größer sein. Die einzelne Prüfzelle 76 beinhaltet:
a) Einen zweifach dotierten Vorsprung 19. Die zweifache Dotierung ermöglicht das Durchschalten positiver und negativer Prüfspannungen und Prüfströme, d.h. von Prüfsignalen;
b) die elektronischen Schalter 30 und 31 zur Durchschaltung des durch diesen Vorsprung 19 gebildeten Tastpunktes 9 an zwei Prüfleitungen 77 und 78, die durch Beschichtung der H-Platte 10 bzw. ihres betreffenden Bauelementes 15 oder 16 hergestellten Leiterbahnen entsprechen;
c) die zwei vorzugsweise als Registerzellen oder modifizierte Registerzellen zur Ansteuerung der elektronischen Schalter 30, 31 ausgebildeten Steuerkomponenten 32 und 33, die in die H-Platte 10 bzw. in ihr betreffendes Bauelement integriert sind. Diese Steuerkomponenten 32, 33 können vorzugsweise Logikgatter und je ein statisches Register beinhalten. Ihr Aufbau kann bspw. dem konventioneller oder weitgehend konventioneller Speicherzellen (RAM) entsprechen. Vorzugsweise kann vorgesehen sein, daß zwei unterschiedliche Steuermodi vorgesehen sind:
   I. Schalten der Schalter 30, 31 anhand von in der Prüfschaltung für den betreffenden Prüfling gespeicherten Informationen (Speichermode).
   II. Schalten der Schalter 30, 31 durch Adressierung der Prüfzellen 76 über nicht dargestellte Adressleitungen (Dekodermode).

   Diese Modi erlauben gezieltes Durchschalten aller oder der für die Prüfung des jeweiligen Prüflings programmierten Prüfzellen 76 der Prüfvorrichtung nach einem Muster in Speichermode oder alternativ schnelles Absuchen im Dekodermode. Solche Prinzipien der Speichermode und der Dekodermode bedürfen für den Fachmann keiner weiteren Erläuterung.
d) Stromversorgungsleitungen für die Prüfzelle 76. Die Steuerkomponenten 32, 33 und die Schalter 30, 31 der einzelnen Prüfzelle sind galvanisch getrennt und besitzen daher getrennte Stromversorgungen. Diese Stromversorgungen können bspw. durch die Prüfleitungen 77, 78 und durch zwei nicht dargestellte Leitungen erreicht werden.
e) Steuer- und Adressleitungen. Die Adressleitungen kann man bspw. auch als Adressenleitungen bezeichnen. Für alle Prüfzellen 76 werden, jeweils getrennt für das p-Gebiet 21 und das n-Gebiet 22 sechs zusätzliche Steuer- und Adressleitungen verwendet, wie dies Fig. 17 zeigt.
   - I.: X Adressierung der Spalte des Rasters, in welcher sich der betreffende Tastpunkt 9 befindet.
   - II.: Y Adressierung der Zeile des Rasters, in welcher sich der betreffende Tastpunkt 9 befindet.
   - III.: WE (Write Enable) Schreibsignal zur Datenspeicherung.
   - IV.: DIN (Data In) Dateneingangskanal.
   - V.: DOUT (Data Out) Datenausgangskanal.
   - VI.: DE (Direct Enable) Unschaltung Speichermode Dekodermode.

Die Leitungen I bis V sind konventionelle Technik bei der Herstellung von Speicher-IC's. Leitung VI entscheidet darüber, ob die Durchschaltung der Schalter 30 und 31 der betreffenden Prüfzelle 76 anhand der in einem Speicher der Prüfschaltung, der vorzugsweise als Register ausgebildet sein kann, gespeicherten Daten (Speichermode) oder durch die angelegte Adresse erfolgt.

Die Adressierung der Prüfzellen kann in konventioneller Technik durch die Dekodierung von Zeilen und Spalten des Rasters in einem Dekodierbaustein der Prüfschaltung erreicht werden. Dieser Dekodierbaustein kann in die H-Platte oder in eine H-Platte integriert sein, muß aber nicht auf ihr enthalten sein. Beispielsweise kann er in die Platte 12 integriert sein oder in einem außerhalb dieser Platten 10 und 12 angeordneten und mit der H-Platte 10 in elektrischer Verbindung stehenden Gerät 40 (Fig. 1) oder dgl. stehen, das auch noch andere Teile der Prüfschaltung oder in manchen Fällen die gesamte Prüfschaltung und ihren elektrischen Anschluß an das Stromnetz aufweisen kann.

Das einzelne Bauelement 15, 16 kann einen Chip oder Wafer bilden, wobei seine Größe bspw. 50 mm x 50 mm betragen oder auch noch größer oder kleiner sein kann. Ein etwaiger Ausfall von einzelnen Tastpunkten der Prüfvorrichtung während der Prüfung eines Prüflings bspw. durch nicht ausreichende elektrische Kontaktierung des betreffenden Prüfpunktes des Prüflings ist im Hinblick auf die hohen Tastpunktdichten praktisch ohne Bedeutung, da keine hundertprozentige Kontaktierung der Prüfpunkte nötig ist, wenn die Methode der Mehrfach- oder Vielfachtastung angewendet wird.

Ein solches Bauelement 15 bzw. 16 kann eine extrem hohe Anzahl von Prüfzellen 76 enthalten, bspw. mehrere Hunderttausend bis mehrere oder viele Millionen. Die in eine H-Platte 10 bzw. in ein Bauelement, wie 15 bzw. 16, integrierten elektronischen Komponenten, Leiterbahnen und dgl., können auf derselben oder auf entgegengesetzten Seiten der H-Platte bzw. des Bauelementes und/oder auch innerhalb von ihnen vorgesehen sein.

Das einzelne Bauelement kann, wie ein gewöhnliches RAM über Adress- und Datenleitungen sowie über entsprechende Steuerleitungen angesteuert werden, wie es bspw. im Prinzip für das Adressieren und Lesen von Tastpunkten durch die US-PS 4,443,756 und 4,528,500 bekannt ist.

Um bspw. mittels einer eine Vielzahl von Prüfzellen 76 nach Fig. 13 aufweisenden Prüfvorrichtung die Prüfung eines Prüflings durchzuführen, dessen Leiterbahnen an ihren Endbereichen durch jeweils eine mehr oder weniger große Anzahl von aktivierbaren, d. h. zuschaltbaren Tastpunkten 9 kontaktiert sind, kann man bspw. u.a. folgenden Verfahrensablauf vorsehen, wie er nachfolgend anhand der Fig. 3 beschrieben wird. Das p-Gebiet 21 eines Vorsprunges 19′ wird durch Schließen seines zugeordneten Schalters 30 mit einem Prüfsignal beaufschlagt. Es werden dann, während dieser Schalter 30 geschlossen bleibt und so das Prüfsignal diesen Vorsprung 19′ fortdauernd beaufschlagt, alle den zur Aktivierung programmierten übrigen Vorsprüngen 19 zugeordneten Schalter 31 der Prüfvorrichtung aufeinanderfolgend kurzzeitig geschlossen und danach der genannte Schalter 30 wieder geöffnet. Dies sei als Prüfzyklus mit dem betreffenden Vorsprung 19′ bezeichnet. Danach finden mit den übrigen fünf Vorsprüngen 19′ entsprechende Prüfzyklen statt oder können stattfinden. Wird bei mindestens einem dieser Prüfzyklen oder einer vorbestimmten Anzahl der Prüfzyklen Fehlerfreiheit festgestellt, dann wird diese Leiterbahn als fehlerfrei attestiert und zur entsprechenden Prüfung der nächsten Leiterbahn übergegangen usw., bis alle Leiterbahnen als fehlerfrei attestiert sind. Es kann auch vorgesehen sein, daß die Prüfung einer Leiterbahn zur Zeitersparnis abgebrochen wird, sobald ihre Fehlerfreiheit festgestellt ist. Ist dagegen eine Leiterbahn als fehlerhaft erkannt worden, wird dies registriert und es kann die Prüfung des Prüflings abgebrochen werden oder es kann die Prüfung noch fortgesetzt werden, wenn man alle Fehler des Prüflings registrieren will. Beispielsweise können ermittelte Fehler nach den Koordinaten des Rasters angezeigt oder ausgedruckt werden.

Anstatt die Prüfung einer Leiterbahn, wie bspw. der Leiterbahn 26, abzubrechen, sobald ihre Fehlerfreiheit oder ein Fehler festgestellt ist, kann die Prüfung dieser Leiterbahn auch fortgesetzt werden und die weiteren ihre Intaktheit oder ihren Fehler anzeigenden Prüfsignale ändern dann an diesem Ergebnis nichts mehr.

Es sei noch erwähnt, daß die Halbleiterscheibe, aus der das einzelne Bauelement 15 oder 16 hergestellt ist, bereits vor der mikromechanischen und mikroelektronischen Bearbeitung p-dotiert oder n-dotiert oder auch undotiert sein kann.

Die Höhe der Vorsprünge 19 kann vorzugsweise in der Größenordnung von 0,1 mm liegen, jedoch auch größer oder kleiner sein. Infolge ihrer sehr geringen Querschnittsabmessungen federn sie axial ausreichend. Auch kann der Hauptbereich der H-Platte bzw. des betreffenden Bauelementes, von dem aus die Vorsprünge vorstehen, benachbart den Vorsprüngen mitfedern. Es sei in diesem Zusammenhang darauf hingewiesen, daß Silizium besonders gute Federeigenschaften hat, die mit denen von Stahl vergleichbar sind, so daß es besonders vorteilhaft ist, wenn die H-Platte 10 auf Siliziumbasis hergestellt ist, und zwar insbesondere aus einem Silizium-Einkristall.

In den Fig. 10 - 12 sind Ausschnitte aus einer ein- oder mehrteiligen H-Platte 10 einer Prüfvorrichtung dargestellt, die zusätzliche Tastpunkte 9 aufweist, die nicht dem mechanischen Kontaktieren der Püfpunkte der Prüflinge dienen, sondern dem berührungslosen Tasten von Prüflingen, wie 24, mittels Spulen 45. Diese Spulen 45 sind hier auf mikromechanischem Wege einstückig mit der übrigen H-Platte 10 hergestellt. Jede Spule 45 weist in diesem Ausführungsbeispiel ein einheitlich stark dotiertes Gebiet auf, also ein p-dotiertes oder ein n-dotiertes Gebiet, das als elektrischer Leiter dient. Oder sie kann auch eine als elektrischer Leiter dienende metallische Beschichtung aufweisen. Im ersteren Falle kann sie nur mit bspw. Impulszüge bildenden, von der Prüfschaltung gelieferten Prüfsignalen derselben Polarität gespeist werden. In letzterem Fall kann sie mit Wechselstrom gespeist werden. Jede solche Spule 45 weist hier eine einzige nicht vollständig geschlossene Windung auf, deren beiden Enden an eine allen Spulen 45 gemeinsame Spannungsquelle angeschlossen sind, wobei alle Spulen zueinander parallelgeschaltet und einzeln unabhängig voneinander mittels je eines in die H-Platte 10 integrierten, in Fig. 10 als Schalter 46 dargestellten Transistors an die gemeinsame Spannungsquelle anschließbar sind. Jede Spule 45 kann so als Sendeantenne zum Aussenden eines elektromagnetischen Wechselfeldes zu dem ihr jeweils gegenüberstehenden Prüfpunkt 7 eines Prüflinges 24 dienen oder mittels eines ebenfalls einen Transistor bildenden Schalters 47 als Empfangsantenne an eine Prüfleitung 79 der Prüfschaltung angeschlossen werden. Die Schalter 46, 47 werden über zugeordnete Steuerkomponenten 48, 48′, die bspw. Register sein können, angesteuert. Statt die Spule 45 mit einer einzigen Windung zu versehen, kann sie auch mehrere Windungen aufweisen und je nach mikromechanischen Möglichkeiten kann sie ggfs. nicht nur als in einer Ebene liegende Spule, sondern auch als dreidimensionale Spule mit mehreren übereinanderliegenden Wicklungen ausgebildet werden.

Die zusätzliche berührungslose Prüfung eines Prüflings kann bspw. wie folgt erfolgen. Je nach Größe des Prüflings und dessen Prüfpunkten können alle oder nur eine Teilanzahl der Spulen 45 in das sie an die Prüfschaltung anschließende Programm einprogrammiert sein. Jede dieser programmierten Spulen 45 kann nun als Sendeantenne dienen und mittels des ihr zugeordneten Schalters 46 hierzu eingeschaltet werden. Dabei werden mindestens zwei Spulen 45 an die Spannungsquelle angeschlossen, und wenn dies erzolgt ist, werden dann die übrigen Spulen 45 aufeinanderfolgend alternativ als Empfangs-Antenne an eine Empfangsschaltung angeschlossen. Jede auf Empfang geschaltete Spule 45 wird dabei nur dann von einem von der Prüfschaltung fühlbaren Strom durchflossen, wenn sie einem Prüfpunkt 7 gegenübersteht, der in elektrischer Verbindung mit dem der momentan auf Senden geschalteten Spule 45 gegenüberliegenden Prüfpunkt 7 des Prüflings steht, also derselben Leiterbahn oder einer mit dieser kurzgeschlossenen Metallfläche des Prüflings wie die momentane Sendespule gegenübersteht. Die "Empfangsspulen" 45 werden so aufeinanderfolgend daraufhin überprüft, welche von ihnen über dieselbe metallisch leitende Fläche des Prüflings mit dem der jeweiligen "Sendespule" gegenüberliegenden Prüfpunkt des Prüflings in Verbindung steht. Es können dann nacheinander allen Prüfpunkten des Prüflings gegenüberstehenden Spulen aufeinanderfolgend alternativ als Sendespulen eingeschaltet und jeweils geprüft werden, welche der nunmehr als Empfangsspulen dienenden Spulen 45 demselben metallisch leitenden Bereich des Prüflings gegenüberstehen und so etwaige Fehler des Prüflings vorzugsweise koordinatenmäßig erfaßt werden.

Auch hier ist es möglich, mittels solcher Spulen 45 eine Einfach- oder Mehrfach- oder Vielfachprüfung jedes elektrisch leitenden Bereichs des Prüflings durchzuführen und gegebenenfalls auch eine Abbildung der oberflächig befindlichen metallischen Bereiche des betreffenden Prüflings darzustellen oder zu speichern. Und zwar können diese Spulen außerordentlich kleine Dimensionen haben, bspw. Durchmesser in der Größenordnung von 5 bis 100 Mikrometern oder ggfs. auch noch kleiner oder auch größer sein. Diese Spulen 45 können wieder in einem einheitlichen Raster an der Vorderseite der H-Platte 10 angeordnet sein, bspw. in einem Raster mit einem Rastermaß von 10 bis 100 Mikrometern oder auch in noch kleineren oder größeren Rastermaßen.

In den Fig. 14 und 15 ist ein Ausführungsbeispiel einer Prüfvorrichtung 6 dargestellt, das sich von den vorangehenden Ausführungsbeispielen dadurch unterscheidet, daß seine Tastpunkte 9 nicht durch Vorsprünge einer H-Platte 10, sondern durch metallische Kontaktnadeln 49, und zwar durch deren vorderen Enden gebildet sind, bspw. durch Nadeln 49 aus Stahl, Kupfer-Beryllium oder anderen federelastischen Metallen guter elektrischer Leitfähigkeit.

Die rückwärtigen, gerundeten Enden der Kontaktnadeln sind in napfförmigen, hier kegelförmigen Vertiefungen 51 - nachfolgend Napf genannt - einer H-Platte angeordnet, bspw. einer Halbleiter-Platte 10 auf Siliziumbasis, insbesondere eines Wafers oder Chips gelagert. Jeder solcher Napf 51 bildet ein Widerlager 52 für die betreffende Kontaktnadel. In diesem Ausführungsbeispiel befindet sich jeder Napf 51 in einem nur ihm zugeordneten kleinen Halbleiter-Bezirk 35 der H-Platte 10, der zur Hälfte stark p-dotiert (Gebiet 21) und zur anderen Hälfte stark n-dotiert (Gebiet 22) ist. Die Trennungsfläche zwischen diesen beiden dotierten Gebieten kann bspw. eine Symmetrieebene des Napfes 51 sein. Wie im Ausführungsbeispiel nach Fig. 13 kann jedes dieser beiden Gebiete 21, 22 an je einen in die H-Platte 10 integrierten elektronischen Schalter 30, 31 angeschlossen sein, der durch das betreffende Gebiet 21 bzw. 22 mitgebildet ist und mittels ihm zugeordneten, nicht dargestellten Steuerkomponenten, wie Register oder dgl., ein- und ausgeschaltet werden kann zur Prüfung von Prüflingen. Für die Durchführung einer Prüfung und der Auswertung können also die zur Fig. 13 gemachten Ausführungen entsprechend auch hier gelten.

Die Kontaktnadeln 49 sind in diesem Ausführungsbeispiel Biegenadeln und ihre vorderen Endbereiche sind nahe unterhalb ihrer die Tastpunkte 9 bildenden oberen Spitzen, von denen hier jede einem Prüfpunkt 7 eines an einem vertikal auf- und abwärts bewegbaren Träger 25 festgehaltenen Prüflings 24 gegenübersteht, in einer oberen Führungsplatte 53 und ihre rückwärtigen Endbereiche sind nahe ihrer unteren freien Enden in einer rückwärtigen Führungsplatte 54 eines im ganzen mit 60 bezeichneten Prüfadapters geführt.

Die obere und die untere Führungsplatte 53, 54 weisen Durchgangsbohrungen auf, in denen die Kontaktnadeln 49 mit Gleitlagerspiel geführt sind.

Ferner durchdringen diese Kontaktnadeln 49 mit mittleren Bereichen Löcher einer horizontal hin und her bewegbaren, ihrem Spannen dienende Spannplatte 55, welche Löcher wesentlich größer im Durchmesser als die Löcher in den Führungsplatten 53, 54 sind.

Die Kontaktnadeln 49 haben unmittelbar unterhalb der unteren Führungsplatte 54 Verbreiterungen in Form von Eindrückungen, die verhindern, daß die Nadeln 49 sich aus ihren unbelasteten Normalstellungen nach oben verschieben können. Die Spannplatte 55 wird vor Durchführung der Prüfung eines am Träger 25 gehaltenen Prüflings 24 mittels eines eine Kolben-Zylindereinheit bildenden, an eine Druckluftquelle anschließbaren Stellmotors 57 nach links gezogen, wodurch die Tastpunkte 9 bildenden oberen Kontaktspitzen der Kontaktnadeln 49 nach unten gezogen werden. Dann wird der Prüfling 24 soweit nach unten bewegt, daß er diese Kontaktspitzen berührt oder fast berührt und dann wird die Spannplatte 55 mittels des Stellmotors 57 nach rechts geschoben, wodurch die Kontaktspitzen auf die Prüfpunkte 7 mit vorbestimmter Kraft zur Herstellung sicheren elektrischen Kontaktes drücken. Auch ihre unteren Enden kommen hierdurch in entsprechend sicheren elektrischen Kontakt mit den sie aufnehmenden Vertiefungen 51 der H-Platte 10. Nunmehr erfolgt die Prüfung des Prüflings 24, bspw. eines Chips, auf Fehlerfreiheit durch die Prüfschaltung dieser Prüfvorrichtung. Die elektrische Prüfung kann u.a. auch so durchgeführt werden, wie es bei bekannten Prüfvorrichtungen, deren Prüfadapter metallische Kontaktstifte aufweisen, an sich bekannt ist.

Die Kontaktnadeln können extrem kleine Durchmesser von bspw. 0,01 bis 0,2 mm haben und gemäß einem Raster von bspw. 0,254 mm oder auch in einem größeren oder noch kleinerem Raster oder auf sonstige gewünschte Weise angeordnet sein.

Der Kolben 63 des Stellmotors 57 ist durch Druckluft nach links und beim Ablassen der Druckluft durch eine Feder 64 nach rechts bewegbar.

Bei dem Ausführungsbeispiel nach Fig. 14 läßt sich die Tastpunktdichte ohne weiteres auch wesentlich größer vorsehen, bspw. so groß, daß in der dargestellten Schnittebene die einzelne Leiterbahn oder das einzelne Pad des Prüflings 24 durch mehrere Kontaktnadeln kontaktiert wird.

In Fig. 16A ist ausschnittsweise eine Abwandlung der Prüfvorrichtung 6 nach Fig. 14 dargestellt. Hier sind die Kontaktnadeln 49 als sogenannte Starrstifte ausgebildet, die durch den jeweiligen Prüfling 24 nur axial belastet werden, ohne hierbei gebogen zu werden.

Diese Kontaktnadeln 49, von denen zwei dargestellt sind, und von denen die Prüfvorrichtung eine große Anzahl aufweisen kann, sind in Durchgangsbohrungen einer vorderen und einer rückwärtigen Führungsplatte 53, 54 axial gleitbar gelagert. Ebenfalls fest mit den fest miteinander verbundenen horizontalen Führungsplatten 53, 54 ist eine ebenfalls nur in einem kleinen dargestellten, geschnittenen Ausschnitt dargestellte H-Platte 10 verbunden, die mikromechanisch hergestellte, mit ihr einstückige, schräg gerichtete, bspw. zylindrische oder blattfederartig gestaltete Vorsprünge 19′′′ aufweist, von denen jeder obenseitig eine napfförmige Vertiefung 51 (Fig 16B) aufweist, in die das rückwärtige Ende einer Kontaktnadel 49 eingreift, so daß die Kontaktnadeln 49 an diesen elastisch federnden Vorsprüngen 19′′′ axial federnd abgestützt sind. Diese Vorsprünge 19′′′ bilden für die Kontaktnadeln 49 Widerlager 52. Jeder Vorsprung 19′′′ kann zwei nebeneinander angeordnete p- und n-Gebiete 21, 22 aufweisen (Fig.16B, wo diese Gebiete Gebiete je eines nicht dargestellten integrierten Transistors sein können), wie es ähnlich bspw. bei den Vorsprüngen 19 nach Fig. 2D der Fall ist. Diese Vorsprünge 19′′′ dienen so dem elektrischen Anschluß der Kontaktnadeln 49 an die H-Platte 10. Diese Kontaktnadeln 49 können wiederum äußerst geringe Durchmesser aufweisen, bspw. in der Größenordnung von 0,1 mm.

Die Prüfschaltung kann wieder in irgendeiner geeigneten Weise ausgebildet sein, bspw. kann sie Schaltbilder haben, wie sie gleich oder ähnlich bei vorbekannten Prüfvorrichtungen mit Kontaktnadeln bekannt sind. Es können wiederum zweckmäßig in neuartiger Weise die Prüfschaltung oder Teile von ihr in die aus einem oder mehreren Halbleiter-Bauelementen bestehende H-Platte 10 integriert sein. Diese H-Platte 10 ist an einem nicht dargestellten Support gehalten zusammen mit den Führungsplatten 53 und 54.

## Patentansprüche

1. Prüfvorrichtung zum Prüfen von elektrischen oder elektronischen Prüflingen, wie Leiterplatten, vorzugsweise unbestückten Leiterplatten, Chips, Multichip-Systemen oder dergleichen, mit Tastpunkten (9), die beim Prüfen eines Prüflings Prüfpunkten des Prüflings zum Übertragen von Prüfsignalen gegenüberstehen, wobei die Tastpunkte (9) der Prüfvorrichtung in einem solch geringen Abstand zueinander auf einer Platte (10) angeordnet sind, daß zur Ermöglichung einer Mehrfach-Prüfung jeweils einem Prüfpunkt mindestens zwei Tastpunkte (9) gegenüberstehen, **dadurch** **gekennzeichnet**, daß die Tastpunkte als mikromechanisch hergestellte Strukturen (19) auf der Oberfläche der auf Halbleiterbasis hergestellten Platte (10) angeordnet sind, und mit mindestens zwei entgegengesetzt dotierten, auf der Platte (10) angebrachten Halbleitergebieten kontaktiert sind, die Teil einer Prüfschaltung sind, und an denen das Prüfsignal direkt oder über eine metallische Kontaktnadel an den Prüfpunkt abgegeben oder von ihm abgenommen wird.

2. Prüfvorrichtung nach Anspruch 1, **dadurch ge****kennzeichnet**, daß die Strukturen (19) als Vorsprünge (19) ausgebildet sind.

3. Prüfvorrichtung nach Anspruch 2, **dadurch ge****kennzeichnet**, daß die Vorsprünge (19) jeweils zwei dotierte Gebiete (21,22) aufweisen, die sich bis zur Stirnseite der Vorsprünge (19) und damit bis zu den Tastpunkten (9) erstrecken.

4. Prüfvorrichtung nach Anspruch 1, **dadurch ge****kennzeichnet**, daß die Tastpunkte (9) von den vorderen freien Enden von metallischen Kontaktnadeln (49) gebildet sind, deren gegenüberliegende Enden je auf der Oberfläche der mikromechanisch hergestellten Strukturen, die als Widerlager (52) ausgebildet sind, gelagert sind, und daß die mindestens zwei entgegengesetzt dotierten Halbleitergebiete das Widerlager bilden.

5. Prüfvorrichtung an Anspruch 4, **dadurch gekenn****zeichnet**, daß die die elektrische Prüfung des jeweiligen Prüflings durchführende Prüfschaltung, die die Halbleitergebiete zum elektrischen Anschließen der Tastpunkte (9) der Prüfvorrichtung an die Prüfschaltung aufweist, bei der Prüfung eines Prüflings zwischen Tastpunkten (9) der Prüfvorrichtung und ihnen gegenüber befindlichen Prüfpunkten des Prüflings von der Prüfschaltung bewirkbare Prüfsignale überträgt, die in der Prüfschaltung daraufhin auswertbar sind, ob der Prüfling elektrisch fehlerfrei ist oder nicht.

6. Prüfvorrichtung nach Anspruch 1, **da****durch gekennzeichnet**, daß die Platte (10) mit zusätzlichen Tastpunkten zum berührungslosen Übertragen und/oder Empfangen von Prüfsignalen ausgestattet ist.

## Claims

1. Testing apparatus for the testing of electrical or electronic test specimens such as printed circuit boards, preferably printed circuit boards without components, chips, multichip systems and the like, said apparatus having feeler points (9) which, during the testing of a test specimen, face monitoring points on the test specimen for the purpose of transmitting test signals, said feeler points (9) of the testing apparatus being spaced so closely together on a board (10) that, in order to enable multiple testing to take place, at least two feeler points (9) face each monitoring point, **characterised** **in** **that** the feeler points are provided as micromechanically manufactured structures (19) on the surface of the board (10) which is manufactured on a semiconductor base, and said feeler points are bonded with at least two semiconductor regions which are provided on the board (10), are doped with opposite types of impurity and are part of a test circuit, at which regions the test signal is transmitted to the monitoring point or picked up by it either direct or via a metal contact needle.

2. Testing apparatus as claimed in Claim 1, **characterised** **in** **that** the structures (19) are designed as projections (19).

3. Testing apparatus as claimed in Claim 2, **characterised** **in** **that** the projections (19) each have two doped regions (21, 22) which extend as far as the face of the projections (19) and hence as far as the feeler points (9).

4. Testing apparatus as claimed in Claim 1, **characterised** **in** **that** the feeler points (9) are formed by the front free ends of metal contact needles (49) whose opposite ends each rest on the surface of the micromechanically manufactured structures, which are designed as a support (52), and in that the at least two semiconductor regions which are doped with opposite types of impurity form the support.

5. Testing apparatus based on Claim 4, **characterised** **in** **that**, when testing a test specimen, the test circuit which conducts the electrical testing of the test specimen in question and which has the semiconductor regions to provide an electrical connection between the feeler points (9) of the testing apparatus and the test circuit, transmits test signals which can be effected by the test circuit between feeler points (9) of the testing apparatus and, facing them, monitoring points on the test specimen, it then being possible to interpret these signals in the test circuit to determine whether or not the test specimen is free from electrical defects.

6. Testing apparatus as claimed in Claim 1, **characterised** **in** **that** the board (10) is provided with additional feeler points for the contactless transmission and/or reception of test signals.

## Revendications

1. Dispositif de contrôle pour vérifier des pièces électriques ou électroniques à essayer, comme des cartes de circuits imprimés, et de préférence des cartes de circuits imprimés nues, des puces, des systèmes à puces multiples ou similaires, comprenant des points de contact (9) qui, lors de la vérification d'une pièce à essayer, sont situés en face de points d'essai de la pièce à essayer en vue de la transmission de signaux d'essai, les points de contact (9) du dispositif de contrôle étant disposés sur une plaque (10) à une distance entre eux qui est suffisamment faible pour qu'en vue de permettre une vérification multiple, au moins deux points de contact (9) soient à chaque fois situés en face d'un point d'essai, caractérisé par le fait que les points de contact sont disposés, sous la forme de structures (19) fabriquées par voie micromécanique, sur la surface de la plaque (10) qui est fabriquée à base de semi-conducteurs, et qu'ils viennent en contact avec au moins deux zones semi-conductrices dopées de polarités opposées qui sont ménagées sur la plaque (10), qui font partie d'un circuit d'essai et sur lesquelles le signal d'essai est fourni au point d'essai ou reçu de celui-ci, soit directement, soit par l'intermédiaire d'une aiguille de contact métallique.

2. Dispositif de contrôle selon la revendication 1, caractérisé par le fait que les structures (19) sont réalisées sous la forme de parties en saillie (19).

3. Dispositif de contrôle selon la revendication 2, caractérisé par le fait que les parties en saillie (19) présentent chacune deux zones dopées (21, 22) qui s'étendent jusqu'au côté frontal des parties en saillie (19), et donc jusqu'aux points de contact (9).

4. Dispositif de contrôle selon la revendication 1, caractérisé par le fait que les points de contact (9) sont constitués par les extrémités libres antérieures d'aiguilles de contact métalliques (49) dont les extrémités opposées portent chacune sur la surface des structures fabriquées par voie micromécanique qui sont réalisées sous la forme de contre-appuis (52), et par le fait que les deux zones semi-conductrices au moins qui sont dopées en présentant des polarités opposées constituent le contre-appui.

5. Dispositif de contrôle selon la revendication 4, caractérisé par le fait que, lors de la vérification d'une pièce à essayer, le circuit d'essai, lequel réalise la vérification électrique de la pièce à essayer concernée et comporte les zones semi-conductrices destinées à raccorder électriquement les points de contact (9) du dispositif de contrôle au circuit d'essai, transmet entre des points de contact (9) du dispositif de contrôle et les points d'essai de la pièce à essayer qui se trouvent en face d'eux des signaux d'essai qui peuvent être produits par le circuit d'essai et qui peuvent être exploités dans le circuit d'essai en vue de déterminer si la pièce à essayer est exempte ou non de défauts électriques.

6. Dispositif de contrôle selon la revendication 1, caractérisé par le fait que la plaque (10) est pourvue de points d'exploration supplémentaires en vue de transmettre et/ou de recevoir sans contact des signaux d'essai.
